# EUROPEAN PATENT APPLICATION

(11) **EP 4 614 556 A1**
(43) Date of publication of application: **10.09.2025**
(21) Application number: 24206944.1
(22) Date of filing: 16.10.2024
(51) Int. Cl.: H01L 21/768, H01L 23/522, H01L 23/528, H01L 23/532

(54) **SEMICONDUCTOR DEVICE**

(30) Priority: 05.03.2024 KR 20240031596
(71) Applicant: SAMSUNG ELECTRONICS CO., LTD., Yeongtong-gu Suwon-si, Gyeonggi-do 16677 (KR)
(72) Inventor: LEE, Eui Bok, 16677 Suwon-si, Gyeonggi-do (KR); CHA, Seungkeun, 16677 Suwon-si, Gyeonggi-do (KR); BAEK, Jongmin, 16677 Suwon-si, Gyeonggi-do (KR)
(74) Representative: Kuhnen & Wacker Patent- und Rechtsanwaltsbüro PartG mbB

(57) **Abstract**

A semiconductor device includes lower conductive lines on a substrate, and spaced apart from each other in a first direction parallel to an upper surface of the substrate, and a via structure on the lower conductive lines, and electrically connected to the lower conductive lines. The via structure includes a via contact extending in the first direction and is electrically connected to the lower conductive lines, and a barrier pattern on a side surface of the via contact, and on a bottom surface of the via contact between the lower conductive lines. The via contact extends through the barrier pattern and contacts the lower conductive lines.

## Description

### CROSS-REFERENCE TO RELATED APPLICATIONS

This U.S. non-provisional patent application claims priority under 35 U.S.C. § 119 of Korean Patent Application No. 10-2024-0031596, filed on March 5, 2024, the entire contents of which are hereby incorporated by reference.

### BACKGROUND

The present disclosure herein relates to a semiconductor device, and more particularly, to a semiconductor device including a via structure mutually connecting a plurality of conductive lines.

A semiconductor device includes an integrated circuit composed of metal-oxide-semiconductor field effect transistors (MOSFET). As a size and a design rule of the semiconductor device are gradually reduced, the metal-oxide-semiconductor field effect transistors may be scaled down. When the metal-oxide-semiconductor field effect transistors (MOSFET) are scaled down, operation characteristics of the semiconductor device may be degraded. Accordingly, various methods for overcoming limitations caused by high integration of the semiconductor device, and forming the semiconductor device having a desired performance are being studied.

### SUMMARY

The present disclosure provides a semiconductor device with improved electrical characteristics.

An embodiment of the inventive concept provides a semiconductor device including lower conductive lines on a substrate, and spaced apart from each other in a first direction parallel to an upper surface of the substrate, and a via structure on the lower conductive lines, and electrically connected to the lower conductive lines, wherein the via structure includes a via contact extending in the first direction and electrically connected to the lower conductive lines, and a barrier pattern on a side surface of the via contact, and on a bottom surface of the via contact between the lower conductive lines, and wherein the via contact extends through the barrier pattern and contacts the lower conductive lines.

In an embodiment of the inventive concept, a semiconductor device includes a lower insulating film on a substrate, lower conductive lines in the lower insulating film, and spaced apart from each other in a first direction parallel to an upper surface of the substrate, an etch stopping film on the lower insulating film, an upper insulating film on the etch stopping film, a via contact extending through at least a portion of the upper insulating film and the etch stopping film and electrically connected to the lower conductive lines, and a barrier pattern interposed between a side surface of the via contact and the upper insulating film, and extending between the side surface of the via contact and the etch stopping film, wherein the via contact extends in the first direction and is electrically connected to the lower conductive lines, wherein the barrier pattern is interposed between the lower insulating film between the lower conductive lines and a bottom surface of the via contact, and wherein the via contact extends through the barrier pattern and contacts the lower conductive lines.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a cross-sectional view of a semiconductor device according to some embodiments of the inventive concept;
FIGS. 2 to 4 are cross-sectional views of a method for manufacturing a semiconductor device according to some embodiments of the inventive concept;
FIG. 5 is a cross-sectional view of a semiconductor device according to some embodiments of the inventive concept;
FIGS. 6 and 7 are cross-sectional views illustrating a method for manufacturing a semiconductor device according to some embodiments of the inventive concept;
FIG. 8 is a cross-sectional view of a semiconductor device according to some embodiments of the inventive concept;
FIG. 9 is a cross-sectional view illustrating a method for manufacturing a semiconductor device according to some embodiments of the inventive concept;
FIG. 10 is a cross-sectional view of a semiconductor device according to some embodiments of the inventive concept;
FIG. 11 is a cross-sectional view illustrating a method for manufacturing a semiconductor device according to some embodiments of the inventive concept;
FIGS. 12 to 18 are cross-sectional views of a semiconductor device according to some embodiments of the inventive concept;
FIGS. 19 to 22 are cross-sectional views illustrating a method for manufacturing a semiconductor device according to some embodiments of the inventive concept;
FIGS. 23 and 24 are cross-sectional views of a semiconductor device according to some embodiments of the inventive concept;
FIG. 25 is a cross-sectional view illustrating a method for manufacturing a semiconductor device according to some embodiments of the inventive concept;
FIGS. 26 to 31 are cross-sectional views of a semiconductor device according to some embodiments of the inventive concept;
FIG. 32 is a cross-sectional view illustrating a method for manufacturing a semiconductor device according to some embodiments of the inventive concept;
FIG. 33 is a cross-sectional view of a semiconductor device according to some embodiments of the inventive concept;
FIG. 34 is a plan view of a semiconductor device according to some embodiments of the inventive concept;
FIGS. 35 to 37 are respectively cross-sectional views taken along A-A', B-B', and C-C' of FIG. 34;
FIGS. 38 and 39 are plan views of a semiconductor device according to some embodiments of the inventive concept; and
FIG. 40 is a cross-sectional view taken along D-D' of FIGS. 38 and 39.

### DETAILED DESCRIPTION

Hereinafter, the inventive concept will be described in detail by describing example embodiments of the inventive concept with reference to the accompanying drawings. Identical reference numerals are used for the same constituent elements in the drawings, and duplicate descriptions thereof are omitted. As used herein, the term "and/or" includes any and all combinations of one or more of the associated listed items. It will be understood that, although the terms "first," "second," "upper portion," "lower portion," etc. may be used herein to describe various elements or components, these elements or components should not be limited by these terms. These terms are only used to distinguish one element or component from another element or component. Therefore, a first element or component discussed below could be termed a second element or component. It is noted that aspects described with respect to one embodiment may be incorporated in different embodiments although not specifically described relative thereto. That is, all embodiments and/or features of any embodiments can be combined in any way and/or combination.

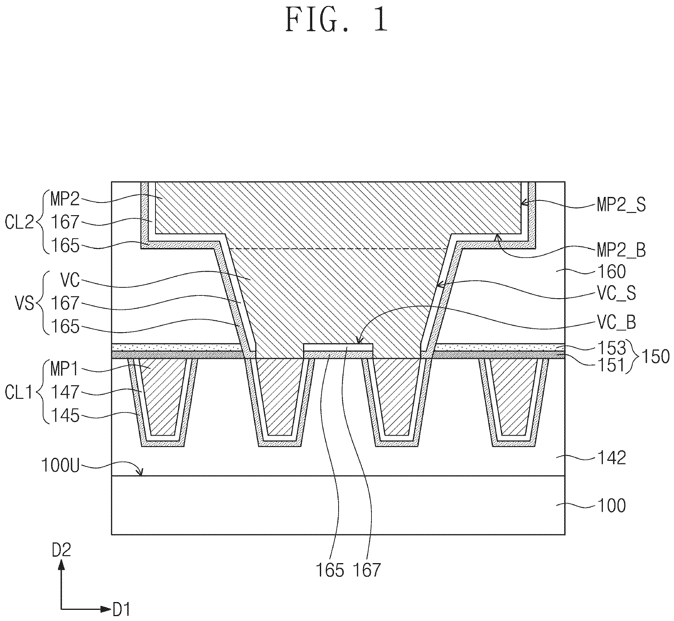

FIG. 1 is a cross-sectional view of a semiconductor device according to some embodiments of the inventive concept.

Referring to FIG. 1, a lower insulating film 142 may be disposed on a substrate 100. The substrate 100 may include a semiconductor substrate. As an example, the substrate 100 may include a silicon substrate, a germanium substrate, or a silicon-on-insulator (SOI) substrate. The lower insulating film 142 may include a silicon oxide film, a silicon nitride film, a silicon oxynitride film, and/or low dielectric constant films.

Lower conductive lines CL1 may be disposed in the lower insulating film 142, and may be spaced apart from each other in a first direction D1 parallel to an upper surface 100U of the substrate 100. Each of the lower conductive lines CL1 may include a lower metal line MP1, a lower barrier pattern 145 between the lower metal line MP1 and the lower insulating film 142, and a lower liner pattern 147 between the lower metal line MP1 and the lower barrier pattern 145. The lower barrier pattern 145 may extend along a side surface and a bottom surface of the lower metal line MP1. The lower liner pattern 147 may be interposed between the side surface of the lower metal line MP1 and the lower barrier pattern 145, and may extend between the bottom surface of the lower metal line MP1 and the lower barrier pattern 145. The lower metal line MP1 may be spaced apart from the lower insulating film 142 with the lower barrier pattern 145 and the lower liner pattern 147 therebetween. The lower metal line MP1 may include a metal (for example, copper). The lower barrier pattern 145 may include Ta, Ti, tantalum nitride (TaN), titanium nitride (TiN), manganese oxide (MnO), and/or manganese nitride (MnN), and the lower liner pattern 147 may include Ru, Co, Mo, Ta, Ti, Ga or an alloy thereof.

An etch stopping film 150 may be disposed on the lower insulating film 142, and may extend onto upper surfaces of the lower conductive lines CL1.

According to some embodiments, the etch stopping film 150 may have a double-layered structure(or bilayer structure) including a first sub-film 151 and a second sub-film 153 sequentially stacked on the lower insulating film 142 along a second direction D2 perpendicular to the upper surface 100U of the substrate 100. The first sub-film 151 may be interposed between the lower insulating film 142 and the second sub-film 153, and may extend between the upper surfaces of the lower conductive lines CL1 and the second sub-film 153. The first sub-film 151 and the second sub-film 153 may include different materials. The first sub-film 151 may include aluminum oxide (AlO), aluminum nitride (AlN), aluminum oxynitride (AlON), SiCN, SiOC, MoN, manganese nitride (MnN), GaN, and/or AlGaN. The second sub-film 153 may include aluminum oxide (AlO), aluminum nitride (AlN), aluminum oxynitride (AlON), SiCN, SiOC, MoN, manganese nitride (MnN), GaN, and/or AlGaN, but may include a material different from that of the first sub-film 151. As an example, the first sub-film 151 may include aluminum oxide (AlO), or aluminum nitride (AlN), and the second sub-film 153 may include SiOC.

According to some embodiments, the second sub-film 153 may be omitted, and in this case, the etch stopping film 150 may have a single-layered structure composed of the first sub-film 151. The etch stopping film 150 may include aluminum oxide (AlO), aluminum nitride (AlN), aluminum oxynitride (AlON), SiCN, SiOC, MoN, manganese nitride (MnN), GaN, and/or AlGaN, and may, in some embodiments, include aluminum oxide (AlO).

An upper insulating film 160 may be disposed on the etch stopping film 150. The upper insulating film 160 may include a silicon oxide film, a silicon nitride film, a silicon oxynitride film, and/or low dielectric constant films.

A via structure VS and an upper conductive line CL2 may be disposed in the upper insulating film 160. The via structure VS may penetrate or extend through a lower portion of the upper insulating film 160 and the etch stopping film 150, and may extend in the first direction D1 to be electrically connected to at least two corresponding lower conductive lines CL1 among the lower conductive lines CL1. The upper conductive line CL2 may penetrate or extend through an upper portion of the upper insulating film 160, and may be electrically connected to the via structure VS. The upper conductive line CL2 may be electrically connected to the at least two corresponding lower conductive lines CL1 through the via structure VS.

The via structure VS may include a via contact VC penetrating or extending through the lower portion of the upper insulating film 160 and the etch stopping film 150, a barrier pattern 165 disposed on a side surface VC_S and a bottom surface VC_B of the via contact VC, and a liner pattern 167 interposed between the side surface VC_S of the via contact VC and the barrier pattern 165 and between the bottom surface VC_B of the via contact VC and the barrier pattern 165. The barrier pattern 165 and the liner pattern 167 may be interposed between the side surface VC_S of the via contact VC and the upper insulating film 160, and may extend between the side surface VC_S of the via contact VC and the etch stopping film 150. The barrier pattern 165 and the liner pattern 167 may be interposed between the lower insulating film 142 between the corresponding lower conductive lines CL1 and the bottom surface VC_B of the via contact VC. The via contact VC may penetrate or extend through the barrier pattern 165 and the liner pattern 167 to be in contact with the corresponding lower conductive lines CL1, and may be in contact with the lower metal line MP1 of each of the lower conductive lines CL1. The barrier pattern 165 on the bottom surface VC_B of the via contact VC may be in contact with the lower insulating film 142 between the corresponding lower conductive lines CL1, and may be in contact with uppermost surfaces of the lower barrier pattern 145 and the lower liner pattern 147 of each of the lower conductive lines CL1. The barrier pattern 165 may be spaced apart from the bottom surface VC_B of the via contact VC with the liner pattern 167 therebetween.

The via contact VC may include a metal (for example, copper), and for example, may be a metal pattern composed of a single metal. That is, in some embodiments, the via contact VC may comprise a monolithic structure composed of a single metal. The barrier pattern 165 may include Ta, Ti, tantalum nitride (TaN), titanium nitride (TiN), manganese oxide (MnO), and/or manganese nitride (MnN), and the liner pattern 167 may include at least one of Ru, Co, Mo, Ta, Ti, Ga, or an alloy thereof.

The upper conductive line CL2 may include an upper metal line MP2 on the via contact VC. According to some embodiments, the upper metal line MP2 may penetrate or extend through the upper portion of the upper insulating film 160 to be in contact with the via contact VC. The upper metal line MP2 may extend across the side surface VC_S of the via contact VC onto the upper insulating film 160 along the first direction D1. The barrier pattern 165 and the liner pattern 167 may extend between the upper metal line MP2 and the upper insulating film 160, and may extend along a bottom surface MP2_B and a side surface MP2_S of the upper metal line MP2. Accordingly, the upper conductive line CL2 may further include the barrier pattern 165 extending along the bottom surface MP2_B and the side surface MP2_S of the upper metal line MP2, and the liner pattern 167 extending between the bottom surface MP2_B of the upper metal line MP2 and the barrier pattern 165, and between the side surface MP2_S of the upper metal line MP2 and the barrier pattern 165.

The upper metal line MP2 may include a metal (for example, copper). According to some embodiments, the via contact VC and the upper metal line MP2 may include the same material (for example, copper). In this case, the via contact VC and the upper metal line MP2 may be in contact with each other without a boundary surface and may form a monolithic structure. According to other embodiments, the via contact VC and the upper metal line MP2 may include different materials (for example, different metals), which may result in a defined boundary between the via contact VC and the upper metal line MP2.

According to embodiments of the inventive concept, the etch stopping film 150 may have a double-layered structure or a single-layered structure, and thus parasitic capacitance of the semiconductor device including the lower conductive lines CL1, the via structure VS, and the upper conductive line CL2 may be reduced. In addition, the via contact VC may be in direct contact with the lower metal line MP1 of each of the corresponding lower conductive lines CL1, and the upper metal line MP2 of the upper conductive line CL2 may be in direct contact with the via contact VC. Accordingly, resistance of the via structure VS electrically connecting the upper conductive line CL2 and the corresponding lower conductive lines CL1 may be reduced. Accordingly, electrical characteristics of the semiconductor device may be improved.

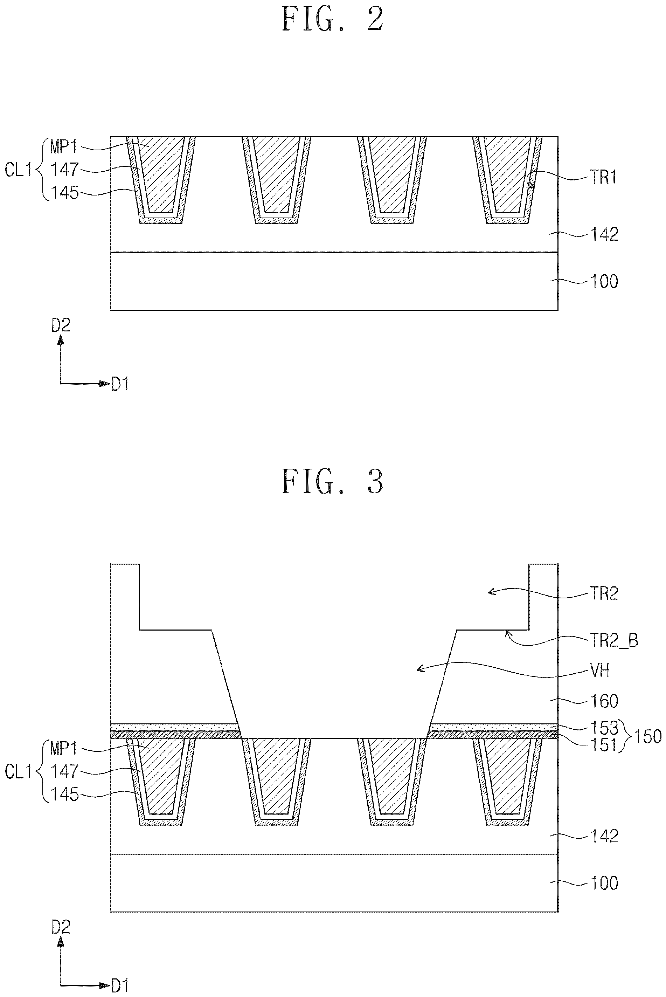

FIGS. 2 to 4 are cross-sectional views illustrating a method for manufacturing a semiconductor device according to some embodiments of the inventive concept. To simplify description, duplicated description for the semiconductor device made with reference to FIG. 1 will be omitted.

Referring to FIG. 2, a lower insulating film 142 may be formed on a substrate 100, and lower trenches TR1 may be formed in the lower insulating film 142. The lower trenches TR1 may be spaced apart from each other in the first direction D1.

Lower conductive lines CL1 may be respectively formed in the lower trenches TR1. For example, forming the lower conductive lines CL1 may include forming, on the lower insulating film 142, a lower barrier film that at least partially fills each of the lower trenches TR1, forming, on the lower barrier film, a lower liner film that partially fills each of the lower trenches TR1, forming, on the lower liner film, a lower conductive film that at least partially fills a residual portion of each of the lower trenches TR1, and planarizing the lower conductive film, the lower liner film, and the lower barrier film until an upper surface of the lower insulating film 142 is at least partially exposed. Each of the lower conductive lines CL1 may include a lower metal line MP1, a lower barrier pattern 145, and a lower liner pattern 147 locally formed in each of the lower trenches TR1 by the planarizing process.

Referring to FIG. 3, an etch stopping film 150 and an upper insulating film 160 may be sequentially stacked on the lower insulating film 142. According to some embodiments, the etch stopping film 150 may have a double-layered structure including a first sub-film 151 and a second sub-film 153. According to other embodiments, the second sub-film 153 may be omitted, and in this case, the etch stopping film 150 may have a single-layered structure composed of the first sub-film 151.

A second trench TR2 may be formed to penetrate or extend through an upper portion of the upper insulating film 160, and a via hole VH may be formed to penetrate or extend through from a bottom surface TR2_B of the second trench TR2 to a lower portion of the upper insulating film 160. The via hole VH may penetrate or extend through the etch stopping film 150, and may extend in the first direction D1 to expose at least two corresponding lower conductive lines CL1 among the lower conductive lines CL1. The via hole VH may at least partially expose the lower metal line MP1 of each of the corresponding lower conductive lines CL1.

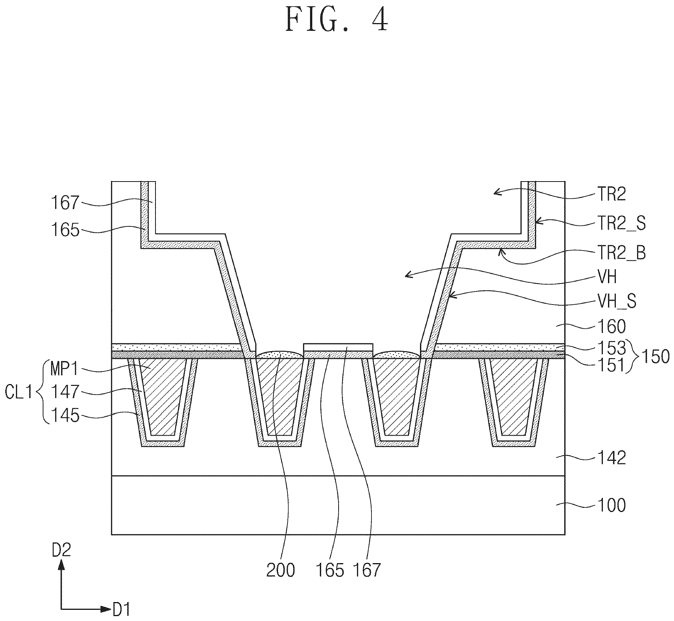

Referring to FIG. 4, a deposition inhibitor 200 may be formed on the lower metal line MP1 exposed by the via hole VH. The deposition inhibitor 200 may include silicon (Si) and/or carbon (C).

A barrier pattern 165 may be formed to conformally at least partially cover an inner surface of the second trench TR2 and the via hole VH, and may be formed on the lower insulating film 142 between the corresponding lower conductive lines CL1. The barrier pattern 165 may not be formed on the lower metal line MP1 on which the deposition inhibitor 200 is formed. The barrier pattern 165 may be formed using a deposition process such as atomic layer deposition, chemical vapor deposition, and physical vapor deposition. Due to the deposition inhibitor 200, the barrier pattern 165 may be selectively deposited on a side surface TR2_S and a bottom surface TR2_B of the second trench TR2, a side surface VH_S of the via hole VH, and the lower insulating film 142 between the corresponding lower conductive lines CL1.

A liner pattern 167 may be formed on the barrier pattern 165. The liner pattern 167 may not be formed on the lower metal line MP1 on which the deposition inhibitor 200 is formed. The liner pattern 167 may be formed using a deposition process such as atomic layer deposition, chemical vapor deposition, and physical vapor deposition. Due to the deposition inhibitor 200, the liner pattern 167 may be selectively deposited on the side surface TR2_S and the bottom surface TR2_B of the second trench TR2, the side surface VH_S of the via hole VH, and the lower insulating film 142 between the corresponding lower conductive lines CL 1.

After the barrier pattern 165 and the liner pattern 167 are formed, the deposition inhibitor 200 may be removed.

Referring to FIG. 1 again, an upper metal line MP2 that at least partially fills a residual portion of the second trench TR2, and a via contact VC that at least partially fills a residual portion of the via hole VH may be formed. For example, forming the upper metal line MP2 and the via contact VC may include forming, on the upper insulating film 160, an upper conductive film that at least partially fills the residual portion of the second trench TR2 and the residual portion of the via hole VH, and planarizing the upper conductive film until an upper surface of the upper insulating film 160 is exposed. For example, forming the upper conductive film may be formed using chemical vapor deposition, physical vapor deposition, an electroplating deposition process, and the like.

The via contact VC may penetrate or extend through the barrier pattern 165 and the liner pattern 167 to be in contact with the lower metal line MP1 of each of the corresponding lower conductive lines CL1.

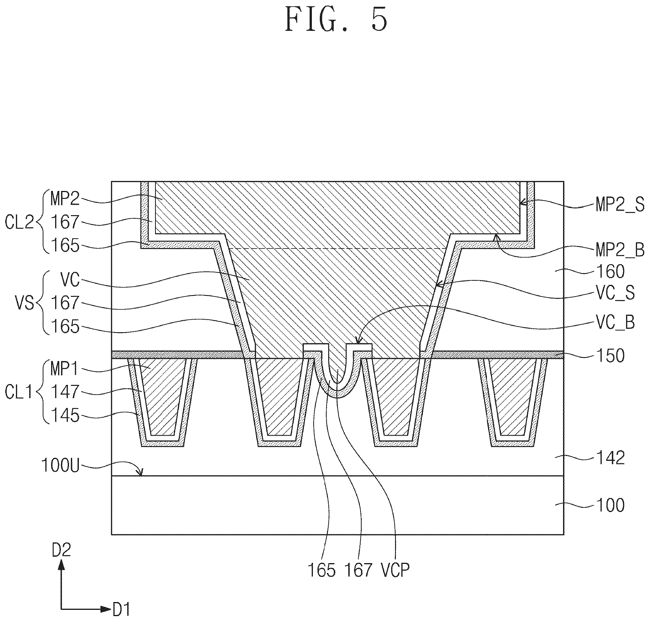

FIG. 5 is a cross-sectional view of a semiconductor device according to some embodiments of the inventive concept. To simplify description, differences from the semiconductor device described with reference to FIG. 1 will be mainly described.

Referring to FIG. 5, the etch stopping film 150 may have a single-layered structure, and may include aluminum oxide (AlO), aluminum nitride (AlN), aluminum oxynitride (AlON), SiCN, SiOC, MoN, manganese nitride (MnN), GaN, and/or AlGaN. For example, the etch stopping film 150 may include aluminum oxide (AlO).

The via contact VC may have a protrusion VCP extending into the lower insulating film 142 between the corresponding lower conductive lines CL1. The protrusion VCP of the via contact VC may be interposed between the corresponding lower conductive lines CL1. The barrier pattern 165 may be interposed between the protrusion VCP and the lower insulating film 142, and the liner pattern 167 may be interposed between the protrusion VCP and the barrier pattern 165. The protrusion VCP of the via contact VC may be spaced apart from the lower insulating film 142 with the barrier pattern 165 and the liner pattern 167 therebetween.

The barrier pattern 165 and the liner pattern 167 may extend onto uppermost surfaces of the lower barrier pattern 145 and the lower liner pattern 147 of each of the corresponding lower conductive lines CL1, and may be in contact with the uppermost surfaces of the lower barrier pattern 145 and the lower liner pattern 147.

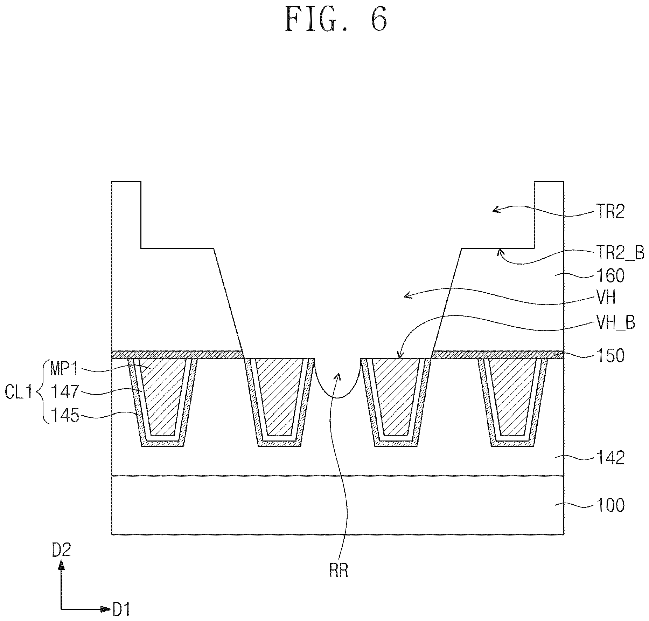

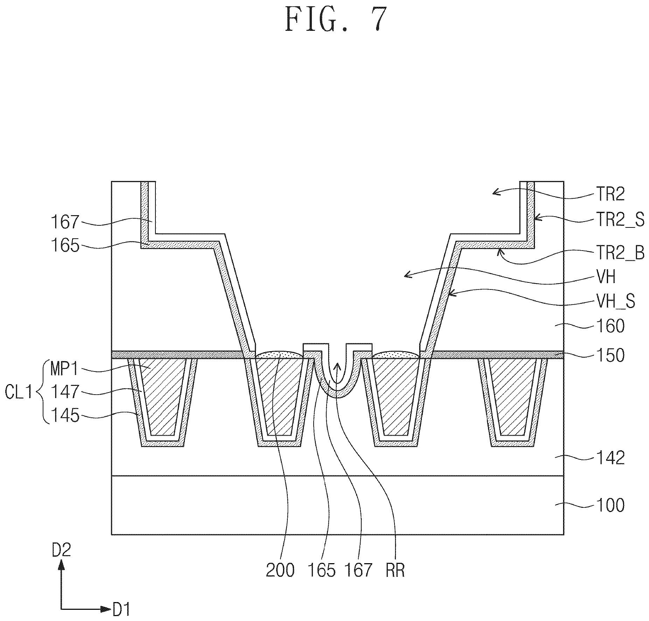

FIGS. 6 and 7 are cross-sectional views illustrating a method for manufacturing a semiconductor device according to some embodiments of the inventive concept. To simplify description, differences from the method for manufacturing a semiconductor device described with reference to FIGS. 2 to 4 will be mainly described.

Referring to FIG. 6, an etch stopping film 150 and an upper insulating film 160 may be sequentially stacked on the lower insulating film 142. According to some embodiments, the etch stopping film 150 may have a single-layered structure.

A second trench TR2 may be formed to penetrate or extend through an upper portion of the upper insulating film 160, and a via hole VH may be formed to penetrate or extend through a lower portion of the upper insulating film 160 from a bottom surface TR2_B of the second trench TR2. The via hole VH may penetrate or extend through the etch stopping film 150, and may at least partially expose at least two corresponding lower conductive lines CL1 among the lower conductive lines CL1. The via hole VH may at least partially expose the lower metal line MP1 of each of the corresponding lower conductive lines CL1. According to some embodiments, a recess region RR may be formed in the lower insulating film 142 between the corresponding lower conductive lines CL1. The recess region RR may extend from a bottom surface VH_B of the via hole VH into the lower insulating film 142 between the corresponding lower conductive lines CL1.

Referring to FIG. 7, a deposition inhibitor 200 may be formed on the lower metal line MP1 exposed by the via hole VH.

A barrier pattern 165 may be formed to conformally at least partially cover inner surfaces of the second trench TR2, the via hole VH, and the recess region RR. The barrier pattern 165 may not be formed on the lower metal line MP1 on which the deposition inhibitor 200 is formed. Due to the deposition inhibitor 200, the barrier pattern 165 may be selectively deposited on a side surface TR2_S and a bottom surface TR2_B of the second trench TR2, a side surface VH_S of the via hole VH, and an inner surface of the recess region RR.

A liner pattern 167 may be formed on the barrier pattern 165. The liner pattern 167 may not be formed on the lower metal line MP1 on which the deposition inhibitor 200 is formed. Due to the deposition inhibitor 200, the liner pattern 167 may be selectively deposited on the side surface TR2_S and the bottom surface TR2_B of the second trench TR2, the side surface VH_S of the via hole VH, and the inner surface of the recess region RR.

After the barrier pattern 165 and the liner pattern 167 are formed, the deposition inhibitor 200 may be removed.

Referring back to FIG. 5, an upper metal line MP2 that at least partially fills a residual portion of the second trench TR2, and a via contact VC that at least partially fills a residual portion of the via hole VH and a residual portion of the recess region RR may be formed. The via contact VC may include a protrusion VCP that at least partially fills a residual portion of the recess region RR. For example, forming the upper metal line MP2 and the via contact VC may include forming, on the upper insulating film 160, an upper conductive film that at least partially fills the residual portion of the second trench TR2, the residual portion of the via hole VH, and the residual portion of the recess region RR, and planarizing the upper conductive film until an upper surface of the upper insulating film 160 is exposed.

The via contact VC may penetrate or extend through the barrier pattern 165 and the liner pattern 167 to be in contact with the lower metal line MP1 of each of the corresponding lower conductive lines CL1.

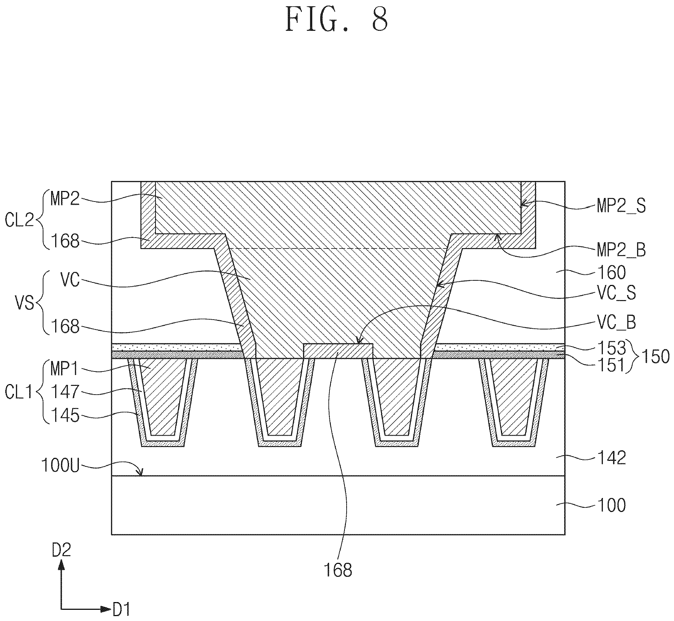

FIG. 8 is a cross-sectional view of a semiconductor device according to some embodiments of the inventive concept. To simplify description, differences from the semiconductor device described with reference to FIG. 1 will be mainly described.

Referring to FIG. 8, the via structure VS may include a via contact VC penetrating a lower portion of the upper insulating film 160 and the etch stopping film 150, and a single barrier pattern 168 disposed on a side surface VC_S and a bottom surface VC_B of the via contact VC. The single barrier pattern 168 may be interposed between the side surface VC_S of the via contact VC and the upper insulating film 160, and may extend between the side surface VC_S of the via contact VC and the etch stopping film 150. The single barrier pattern 168 may be interposed between the lower insulating film 142 between the corresponding lower conductive lines CL1 and a bottom surface VC_B of the via contact VC. The via contact VC may penetrate or extend through the single barrier pattern 168 to be in contact with the corresponding lower conductive lines CL1, and may be in contact with the lower metal line MP1 of each of the corresponding lower conductive lines CL1. The single barrier pattern 168 on the bottom surface VC_B of the via contact VC may be in contact with the lower insulating film 142 between the corresponding lower conductive lines CL1, and may be in contact with uppermost surfaces of the lower barrier pattern 145 and the lower liner pattern 147 of each of the corresponding lower conductive lines CL1. The single barrier pattern 168 may be in contact with the side surface VC_S and the bottom surface VC_B of the via contact VC.

The single barrier pattern 168 may include TaN doped with Ru, Ta, Ru, Mo, MoN, MoMnO, TaS, MoS, a Mn-TaN stacked material, a MnO-TaN stacked material, and/or a carbon-based material (for example, graphene, or a carbon nanotube).

The upper conductive line CL2 may include the upper metal line MP2 on the via contact VC. According to some embodiments, the upper metal line MP2 may penetrate or extend through an upper portion of the upper insulating film 160 to be in contact with the via contact VC. The upper metal line MP2 may extend across a side surface VC_S of the via contact VC onto the upper insulating film 160 along the first direction D1. The single barrier pattern 168 may extend between the upper metal line MP2 and the upper insulating film 160, and may extend along a bottom surface MP2_B and a side surface MP2_S of the upper metal line MP2. Accordingly, the upper conductive line CL2 may further include the single barrier pattern 168 extending along the bottom surface MP2_B and the side surface MP2_S of the upper metal line MP2.

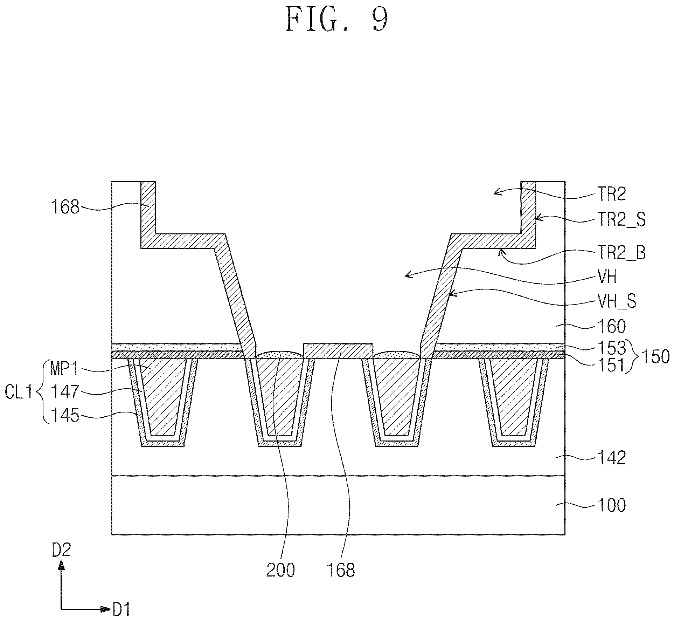

FIG. 9 is a cross-sectional view illustrating a method for manufacturing a semiconductor device according to some embodiments of the inventive concept. To simplify description, differences from the method for manufacturing a semiconductor device described with reference to FIGS. 2 to 4 will be mainly described.

Referring to FIG. 9, a deposition inhibitor 200 may be formed on the lower metal line MP1 exposed by the via hole VH.

A single barrier pattern 168 may be formed to conformally at least partially cover inner surfaces of the second trench TR2 and the via hole VH, and may be formed on the lower insulating film 142 between the corresponding lower conductive lines CL1. The single barrier pattern 168 may not be formed on the lower metal line MP1 on which the deposition inhibitor 200 is formed. The single barrier pattern 168 may be formed using a deposition process such as atomic layer deposition, chemical vapor deposition, and physical vapor deposition. Due to the deposition inhibitor 200, the single barrier pattern 168 may be selectively deposited on a side surface TR2_S and a bottom surface TR2_B of the second trench TR2, a side surface VH_S of the via hole VH, and the lower insulating film 142 between the corresponding lower conductive lines CL1. After the single barrier pattern 168 is formed, the deposition inhibitor 200 may be removed.

Referring back to FIG. 8, an upper metal line MP2 that at least partially fills a residual portion of the second trench TR2, and a via contact VC that at least partially fills a residual portion of the via hole VH may be formed. Forming the upper metal line MP2 and the via contact VC may be formed in the substantially same method as that described with reference to FIGS. 2 to 4. The via contact VC may penetrate or extend through the single barrier pattern 168 to be in contact with the lower metal line MP1 of each of the corresponding lower conductive lines CL1.

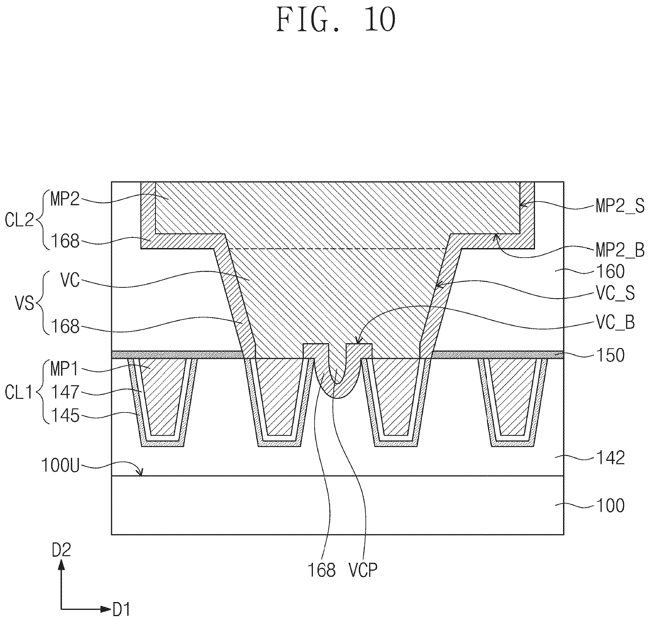

FIG. 10 is a cross-sectional view of a semiconductor device according to some embodiments of the inventive concept. To simplify description, differences from the semiconductor device described with reference to FIG. 8 will be mainly described.

Referring to FIG. 10, the via contact VC may have a protrusion VCP extending into the lower insulating film 142 between the corresponding lower conductive lines CL1. The protrusion VCP of the via contact VC may be interposed between the corresponding lower conductive lines CL1. The single barrier pattern 168 may be interposed between the protrusion VCP and the lower insulating film 142. The protrusion VCP of the via contact VC may be spaced apart from the lower insulating film 142 with the single barrier pattern 168 therebetween. The single barrier pattern 168 may extend onto uppermost surfaces of the lower barrier pattern 145 and the lower liner pattern 147 of each of the corresponding lower conductive lines CL1, and may be in contact with the uppermost surfaces of the lower barrier pattern 145 and the lower liner pattern 147.

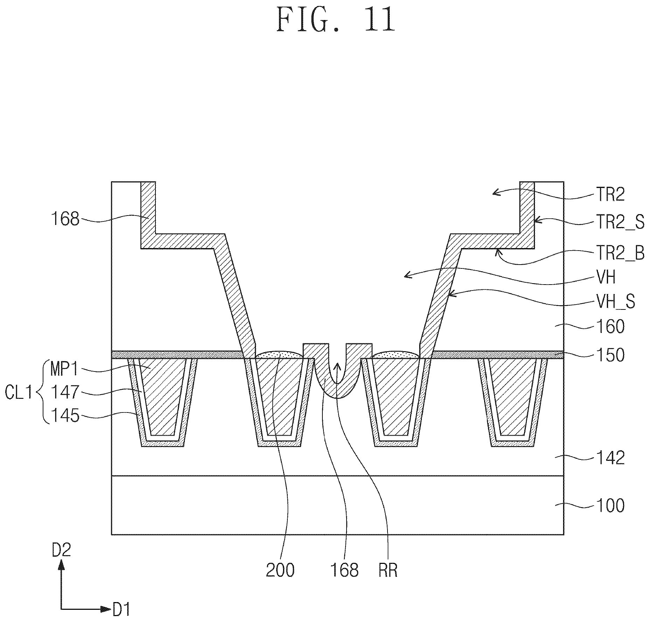

FIG. 11 is a cross-sectional view illustrating a method for manufacturing a semiconductor device according to some embodiments of the inventive concept. To simplify description, differences from the method for manufacturing a semiconductor device described with reference to FIGS. 2 to 4 will be mainly described.

Referring to FIG. 11, an etch stopping film 150 and an upper insulating film 160 may be sequentially stacked on the lower insulating film 142. According to some embodiments, the etch stopping film 150 may have a single-layered structure.

A second trench TR2 may be formed to penetrate or extend through an upper portion of the upper insulating film 160, and a via hole VH may be formed to penetrate or extend through a lower portion of the upper insulating film 160 from a bottom surface TR2_B of the second trench TR2. The via hole VH may penetrate or extend through the etch stopping film 150, and may at least partially expose at least two corresponding lower conductive lines CL1 among the lower conductive lines CL1. The via hole VH may at least partially expose the lower metal line MP1 of each of the corresponding lower conductive lines CL1. According to some embodiments, a recess region RR may be formed in the lower insulating film 142 between the corresponding lower conductive lines CL1. The recess region RR may extend from a bottom surface of the via hole VH into the lower insulating film 142 between the corresponding lower conductive lines CL1.

A deposition inhibitor 200 may be formed on the lower metal line MP1 at least partially exposed by the via hole VH.

A single barrier pattern 168 may be formed to conformally at least partially cover inner surfaces of the second trench TR2, the via hole VH, and the recess region RR. The single barrier pattern 168 may not be formed on the lower metal line MP1 on which the deposition inhibitor 200 is formed. The single barrier pattern 168 may be formed using a deposition process such as atomic layer deposition, chemical vapor deposition, and physical vapor deposition. Due to the deposition inhibitor 200, the single barrier pattern 168 may be selectively deposited on a side surface TR2_S and a bottom surface TR2_B of the second trench TR2, a side surface VH_S of the via hole VH, and an inner surface of the recess region RR. After the single barrier pattern 168 is formed, the deposition inhibitor 200 may be removed.

Referring back to FIG. 10, an upper metal line MP2 that at least partially fills a residual portion of the second trench TR2 may be formed, and a via contact VC that at least partially fills a residual portion of the via hole VH and a residual portion of the recess region RR may be formed. The via contact VC may include a protrusion VCP that at least partially fills the residual portion of the recess region RR. For example, forming the upper metal line MP2 and the via contact VC may include forming, on the upper insulating film 160, an upper conductive film that at least partially fills the residual portion of the second trench TR2, the residual portion of the via hole VH, and the residual portion of the recess region RR, and planarizing the upper conductive film until an upper surface of the upper insulating film 160 is exposed.

The via contact VC may penetrate or extend through the single barrier pattern 168 to be in contact with the lower metal line MP1 of each of the corresponding lower conductive lines CL1.

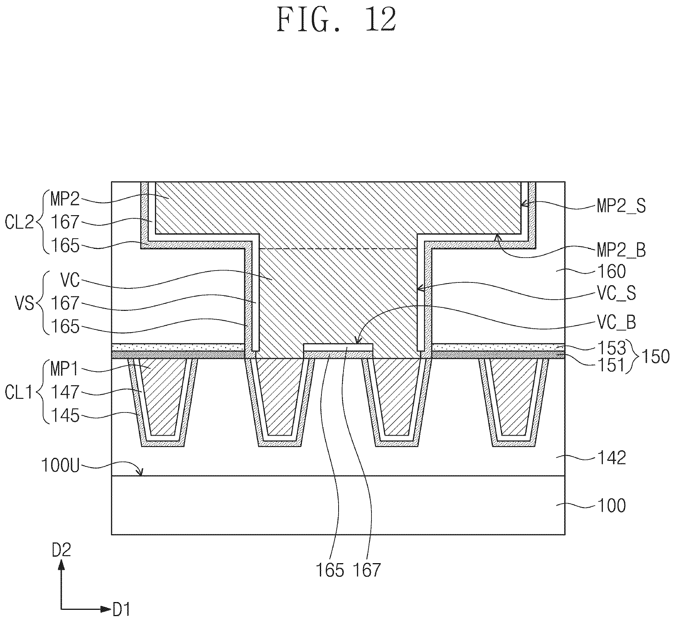

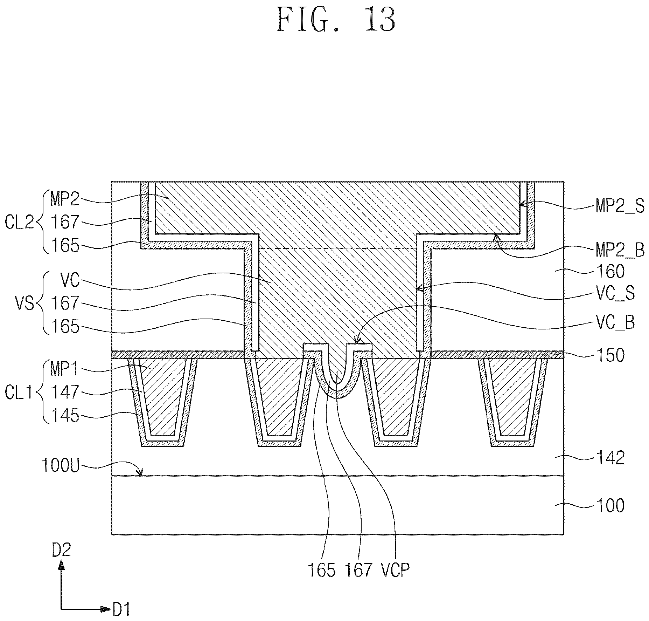

FIGS. 12 and 13 are cross-sectional views of a semiconductor device according to some embodiments of the inventive concept.

Referring to FIGS. 12 and 13, a side surface VC_S of the via contact VC may be substantially perpendicular to an upper surface 100U of the substrate 100. Except for the difference described above, the semiconductor device of FIG. 12 is substantially the same as the semiconductor device described with reference to FIG. 1, and the semiconductor device of FIG. 13 is substantially the same as the semiconductor device described with reference to FIG. 5.

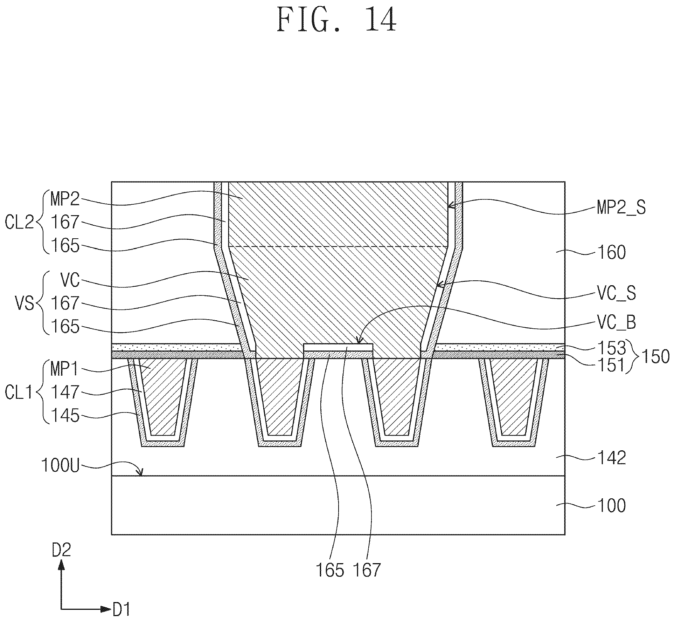

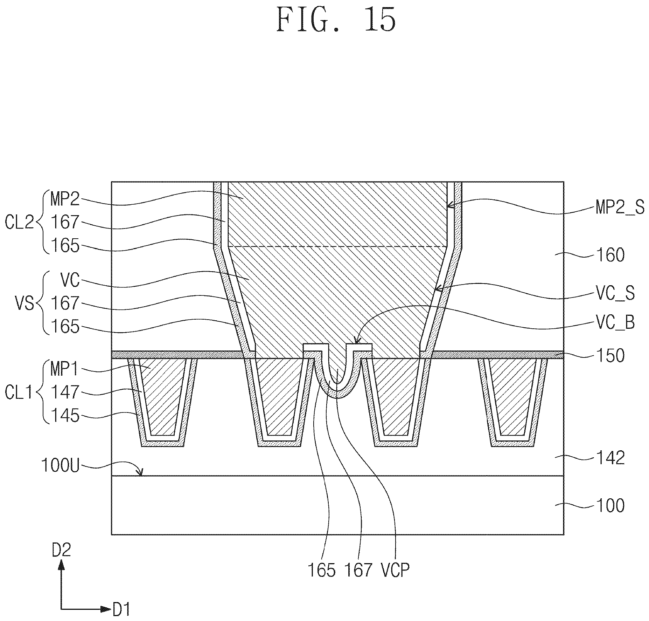

FIGS. 14 and 15 are cross-sectional views of a semiconductor device according to some embodiments of the inventive concept.

Referring to FIGS. 14 and 15, the upper metal line MP2 may extend on the via contact VC in the first direction D1, and a side surface MP2_S of the upper metal line MP2 may be aligned with a side surface VC_S of the via contact VC along the second direction D2. The upper metal line MP2 may have side surfaces MP2_S opposed to each other in the first direction D1, and the via contact VC may have side surfaces VC_S opposed to each other in the first direction D1. The side surfaces MP2_S of the upper metal line MP2 may be respectively aligned with the side surfaces VC_S of the via contact VC along the second direction D2.

Except for the difference described above, a semiconductor device of FIG. 14 is substantially the same as the semiconductor device described with reference to FIG. 1, and a semiconductor device of FIG. 15 is substantially the same as the semiconductor device described with reference to FIG. 5.

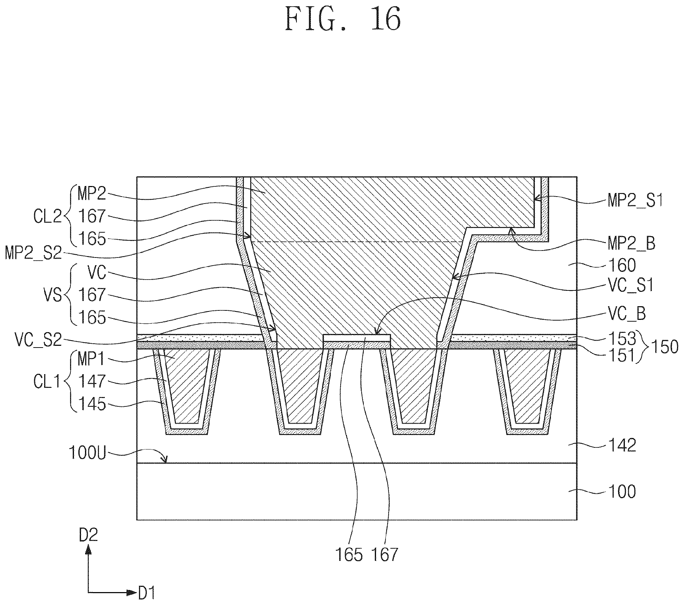

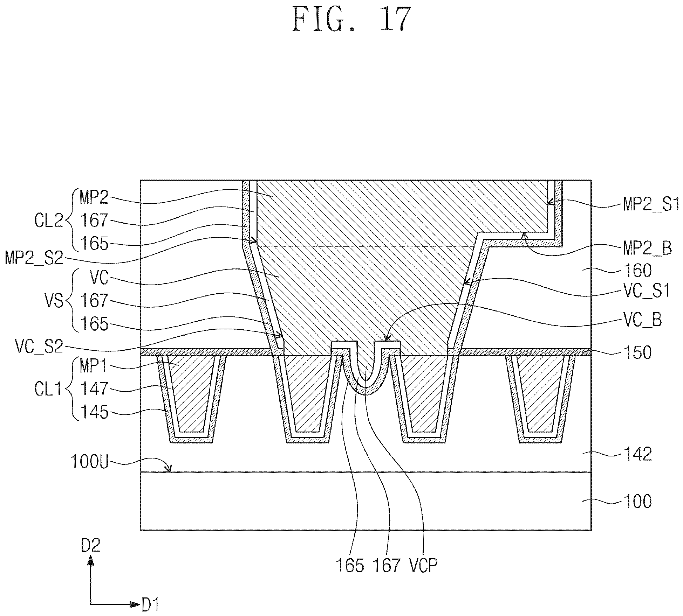

FIGS. 16 and 17 are cross-sectional views of a semiconductor device according to some embodiments of the inventive concept.

Referring to FIGS. 16 and 17, the upper metal line MP2 may extend on the via contact VC in the first direction D1. The upper metal line MP2 may extend across a first side surface VC_S1 of the via contact VC onto the upper insulating film 160 along the first direction D 1. Accordingly, a first side surface MP2_S1 of the upper metal line MP2 may be shifted from the first side surface VC_S1 of the via contact VC along the first direction D 1, and a bottom surface MP2_B of the upper metal line MP2 may extend between the first side surface VC_S1 of the via contact VC and the first side surface MP2_S1 of the upper metal line MP2 in the first direction D1.

According to some embodiments, a second side surface MP2_S2 of the upper metal line MP2 may be aligned with a second side surface VC_S2 of the via contact VC along the second direction D2. The first side surface MP2_S1 and the second side surface MP2_S2 of the upper metal line MP2 may be opposed to each other in the first direction D1, and the first side surface VC_S1 and the second side surface VC_S2 of the via contact VC may be opposed to each other in the first direction D1.

Except for the difference described above, a semiconductor device of FIG. 16 is substantially the same as the semiconductor device described with reference to FIG. 1, and a semiconductor device of FIG. 17 is substantially the same as the semiconductor device described with reference to FIG. 5.

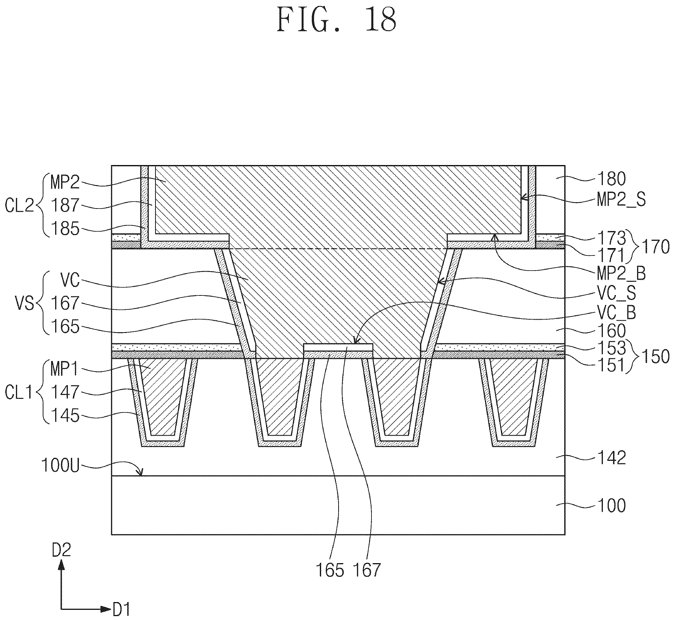

FIG. 18 is a cross-sectional view of a semiconductor device according to some embodiments of the inventive concept. To simplify description, differences from the semiconductor device described with reference to FIG. 1 will be mainly described.

Referring to FIG. 18, a first etch stopping film 150 may be disposed on the lower insulating film 142, and may extend onto upper surfaces of the lower conductive lines CL1. The first etch stopping film 150 is substantially the same as the etch stopping film 150 described with reference to FIG. 1.

A first upper insulating film 160 may be disposed on the first etch stopping film 150. The first upper insulating film 160 is substantially the same as the upper insulating film 160 described with reference to FIG. 1.

A second etch stopping film 170 may be disposed on the first upper insulating film 160.

According to some embodiments, the second etch stopping film 170 may have a double-layered structure(or a bilayer structure) including a third sub-film 171 and a fourth sub-film 173 sequentially stacked on the first upper insulating film 160 along the second direction D2. The third sub-film 171 may be interposed between the first upper insulating film 160 and the fourth sub-film 173. The third sub-film 171 and the fourth sub-film 173 may include different materials. The third sub-film 171 may include aluminum oxide (AlO), aluminum nitride (AlN), aluminum oxynitride (AlON), SiCN, SiOC, MoN, manganese nitride (MnN), GaN, or AlGaN. The fourth sub-film 173 may include aluminum oxide (AlO), aluminum nitride (AlN), aluminum oxynitride (AlON), SiCN, SiOC, MoN, manganese nitride (MnN), GaN, and/or AlGaN, but may include a material different from that of the third sub-film 171. For example, the third sub-film 171 may include aluminum oxide (AlO) and/or aluminum nitride (AlN), and the fourth sub-film 173 may include SiOC.

According to some embodiments, the fourth sub-film 173 may be omitted, and in this case, the second etch stopping film 170 may have a single-layered structure composed of the third sub-film 171. The second etch stopping film 170 may include aluminum oxide (AlO), aluminum nitride (AlN), aluminum oxynitride (AlON), SiCN, SiOC, MoN, manganese nitride (MnN), GaN, and/or AlGaN, and may include, for example, aluminum oxide (AlO).

A second upper insulating film 180 may be disposed on the second etch stopping film 170. The second upper insulating film 180 may include a silicon oxide film, a silicon nitride film, a silicon oxynitride film, and/or low dielectric constant films.

A via structure VS may be disposed in the first upper insulating film 160. The via structure VS may penetrate or extend through the first upper insulating film 160 and the first etch stopping film 150, and may extend in the first direction D1 to be connected to at least two corresponding lower conductive lines CL1 among the lower conductive lines CL1.

An upper conductive line CL2 may be disposed in the second upper insulating film 180. The upper conductive line CL2 may penetrate or extend through the second upper insulating film 180 and the second etch stopping film 170, and may be connected to the via structure VS. The upper conductive line CL2 may be electrically connected to the at least two corresponding lower conductive lines CL1 through the via structure VS.

The via structure VS may include a via contact VC penetrating or extending through the first upper insulating film 160 and the first etch stopping film 150, a barrier pattern 165 disposed on a side surface VC_S and a bottom surface VC_B of the via contact VC, and a liner pattern 167 interposed between the side surface VC_S of the via contact VC and the barrier pattern 165, and between the bottom surface VC_B of the via contact VC and the barrier pattern 165. The barrier pattern 165 and the liner pattern 167 may be interposed between the side surface VC_S of the via contact VC and the first upper insulating film 160, and may extend between the side surface VC_S of the via contact VC and the first etch stopping film 150. The barrier pattern 165 and the liner pattern 167 may be interposed between the lower insulating film 142 between the corresponding lower conductive lines CL1 and the bottom surface VC_B of the via contact VC. The via contact VC may penetrate or extend through the barrier pattern 165 and the liner pattern 167 to be in contact with the corresponding lower conductive lines CL1, and may be in contact with the lower metal line MP1 of each of the corresponding lower conductive lines CL1.

The upper conductive line CL2 may include an upper metal line MP2 penetrating or extending through the second upper insulating film 180 and the second etch stopping film 170, an upper barrier pattern 185 extending along a side surface MP2_S and a bottom surface MP2_B of the upper metal line MP2, and an upper liner pattern 187 interposed between the side surface MP2_S of the upper metal line MP2 and the upper barrier pattern 185, and between the bottom surface MP2 B of the upper metal line MP2 and the upper barrier pattern 185. The upper barrier pattern 185 and the upper liner pattern 187 may be interposed between the side surface MP2_S of the upper metal line MP2 and the second upper insulating film 180, and may extend between the side surface MP2_S of the upper metal line MP2 and the second etch stopping film 170. The upper barrier pattern 185 and the upper liner pattern 187 may further extend between the bottom surface MP2_B of the upper metal line MP2 and the first upper insulating film 160. The upper metal line MP2 may penetrate or extend through the upper barrier pattern 185 and the upper liner pattern 187 to be in contact with the via contact VC.

The upper barrier pattern 185 may include Ta, Ti, TaN, TiN, manganese oxide (MnO), and/or manganese nitride (MnN), and the upper liner pattern 187 may include Ru, Co, Mo, Ta, Ti, Ga, or an alloy thereof.

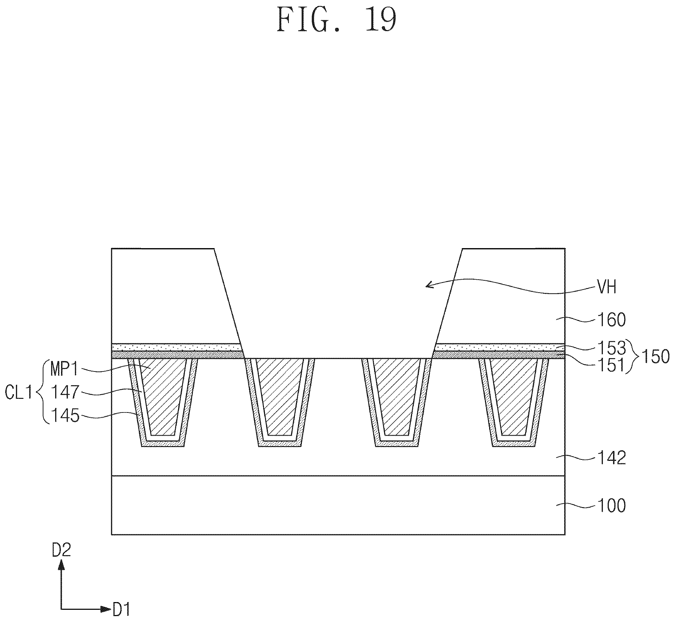

FIGS. 19 to 22 are cross-sectional views illustrating a method for manufacturing a semiconductor device according to some embodiments of the inventive concept. To simplify description, differences from the method for manufacturing a semiconductor device described with reference to FIGS. 2 to 4 will be mainly described.

Referring to FIG. 19, a first etch stopping film 150 and a first upper insulating film 160 may be sequentially stacked on the lower insulating film 142. According to some embodiments, the first etch stopping film 150 may have a double-layered structure including a first sub-film 151 and a second sub-film 153. According to other embodiments, the second sub-film 153 may be omitted, and in this case, the first etch stopping film 150 may have a single-layered structure composed of the first sub-film 151.

A via hole VH may be formed to penetrate or extend through the first upper insulating film 160 and the first etch stopping film 150. The via hole VH may extend in the first direction D1 to expose at least two corresponding lower conductive lines CL1 among the lower conductive lines CL1. The via hole VH may expose the lower metal line MP1 of each of the corresponding lower conductive lines CL1.

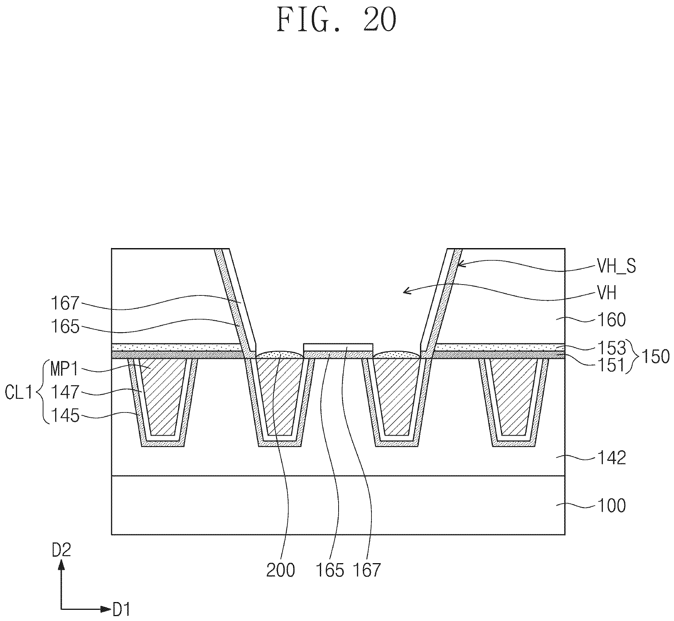

Referring to FIG. 20, a deposition inhibitor 200 may be formed on the lower metal line MP1 exposed by the via hole VH.

A barrier pattern 165 may be formed to conformally at least partially cover an inner surface of the via hole VH, and may be formed on the lower insulating film 142 between the corresponding lower conductive lines CL1. The barrier pattern 165 may not be formed on the lower metal line MP1 on which the deposition inhibitor 200 is formed. Due to the deposition inhibitor 200, the barrier pattern 165 may be selectively deposited on a side surface VH_S of the via hole VH, and the lower insulating film 142 between the corresponding lower conductive lines CL1.

A liner pattern 167 may be formed on the barrier pattern 165. The liner pattern 167 may not be formed on the lower metal line MP1 on which the deposition inhibitor 200 is formed. Due to the deposition inhibitor 200, the liner pattern 167 may be selectively deposited on the side surface VH_S of the via hole VH, and the lower insulating film 142 between the corresponding lower conductive lines CL1.

After the barrier pattern 165 and the liner pattern 167 are formed, the deposition inhibitor 200 may be removed.

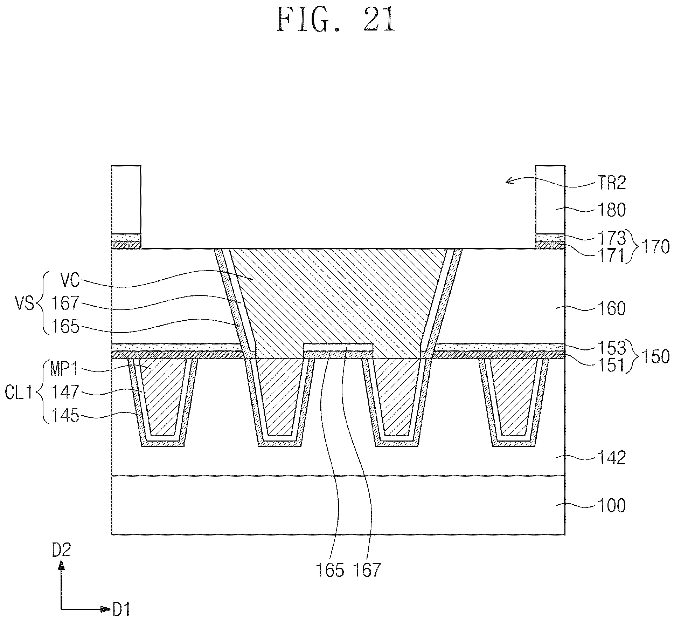

Referring to FIG. 21, a via contact VC that at least partially fills a residual portion of the via hole VH may be formed. For example, forming the via contact VC may include forming, on the first upper insulating film 160, a via conductive film that at least partially fills a residual portion of the via hole VH, and planarizing the via conductive film until an upper surface of the first upper insulating film 160 is exposed. For example, forming the via conductive film may be formed using chemical vapor deposition, physical vapor deposition, an electroplating deposition process, and the like. The via contact VC may penetrate or extend through the barrier pattern 165 and the liner pattern 167 to be in contact with the lower metal line MP1 of each of the corresponding lower conductive lines CL1. The via contact VC, the barrier pattern 165, and the liner pattern 167 may be referred to as a via structure VS.

A second etch stopping film 170 may be formed on the first upper insulating film 160, and may at least partially cover the via structure VS. According to some embodiments, the second etch stopping film 170 may have a double-layered structure including a third sub-film 171 and a fourth sub-film 173. According to other embodiments, the fourth sub-film 173 may be omitted, and in this case, the second etch stopping film 170 may have a single-layered structure composed of the third sub-film 171.

A second upper insulating film 180 may be formed on the second etch stopping film 170. The second etch stopping film 170 may be interposed between the first upper insulating film 160 and the second upper insulating film 180.

A second trench TR2 may be formed to penetrate or extend through the second upper insulating film 180 and the second etch stopping film 170. The second trench TR2 may at least partially expose the via structure VS. The second trench TR2 may at least partially expose an upper surface of the via contact VC, and uppermost surfaces of the barrier pattern 165 and the liner pattern 167.

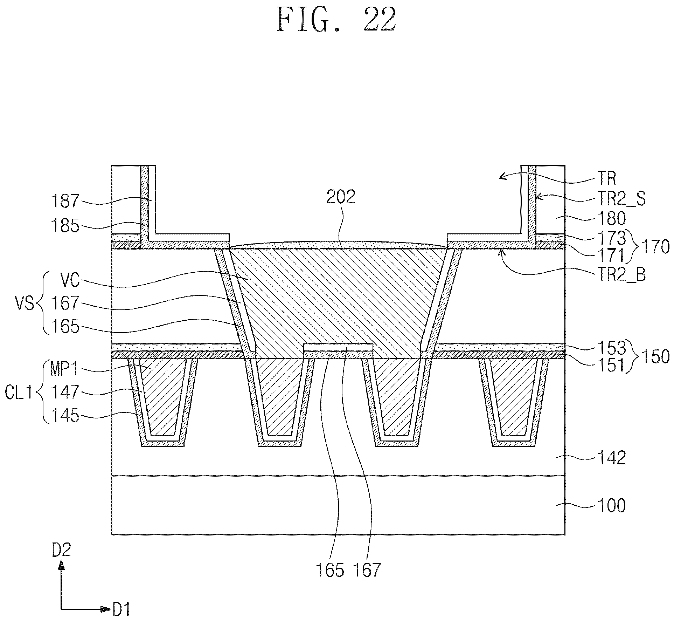

Referring to FIG. 22, an additional deposition inhibitor 202 may be formed on the via contact VC exposed by the second trench TR2. The additional deposition inhibitor 202 may include at least one of silicon (Si) or carbon (C).

An upper barrier pattern 185 may be formed to conformally at least partially cover an inner surface of the second trench TR2. The upper barrier pattern 185 may not be formed on the via contact VC on which the additional deposition inhibitor 202 is formed. The upper barrier pattern 185 may be formed using a deposition process such as atomic layer deposition, chemical vapor deposition, and physical vapor deposition. Due to the additional deposition inhibitor 202, the upper barrier pattern 185 may be selectively deposited on a side surface TR2_S of the second trench TR2, and on a portion of a bottom surface TR2_B of the second trench TR2.

An upper liner pattern 187 may be formed on the upper barrier pattern 185. The upper liner pattern 187 may not be formed on the via contact VC on which the additional deposition inhibitor 202 is formed. The upper liner pattern 187 may be formed using a deposition process such as atomic layer deposition, chemical vapor deposition, and physical vapor deposition. Due to the additional deposition inhibitor 202, the upper liner pattern 187 may be selectively deposited on the side surface TR2_S of the second trench TR2, and on a portion of the bottom surface TR2_B of the second trench TR2.

After the upper barrier pattern 185 and the upper liner pattern 187 are formed, the additional deposition inhibitor 202 may be removed.

Referring back to FIG. 18, an upper metal line MP2 that at least partially fills a residual portion of the second trench TR2 may be formed. For example, forming the upper metal line MP2 may include forming, on the second upper insulating film 180, an upper conductive film that at least partially fills the residual portion of the second trench TR2, and planarizing the upper conductive film until an upper surface of the second upper insulating film 180 is exposed. The upper metal line MP2 may penetrate or extend through the upper barrier pattern 185 and the upper liner pattern 187 to be in contact with the via contact VC.

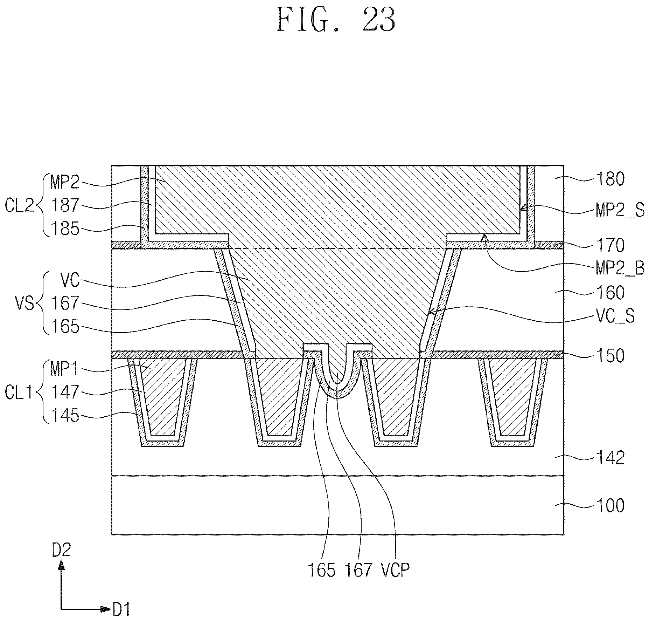

FIG. 23 is a cross-sectional view of a semiconductor device according to some embodiments of the inventive concept. To simplify description, differences from the semiconductor device described with reference to FIG. 18 will be mainly described.

Referring to FIG. 23, each of the first etch stopping film 150 and the second etch stopping film 170 may have a single-layered structure, and may include aluminum oxide (AlO), aluminum nitride (AlN), aluminum oxynitride (AlON), SiCN, SiOC, MoN, manganese nitride (MnN), GaN, and/or AlGaN. For example, each of the first etch stopping film 150 and the second etch stopping film 170 may include aluminum oxide (AlO).

The via contact VC may have a protrusion VCP extending into the lower insulating film 142 between the corresponding lower conductive lines CL1. The protrusion VCP of the via contact VC may be interposed between the corresponding lower conductive lines CL1. The barrier pattern 165 may be interposed between the protrusion VCP and the lower insulating film 142, and the liner pattern 167 may be interposed between the protrusion VCP and the barrier pattern 165. The protrusion VCP of the via contact VC may be spaced apart from the lower insulating film 142 with the barrier pattern 165 and the liner pattern 167 therebetween.

The barrier pattern 165 and the liner pattern 167 may extend onto uppermost surfaces of the lower barrier pattern 145 and the lower liner pattern 147 of each of the corresponding lower conductive lines CL1, and may be in contact with the uppermost surfaces of the lower barrier pattern 145 and the lower liner pattern 147.

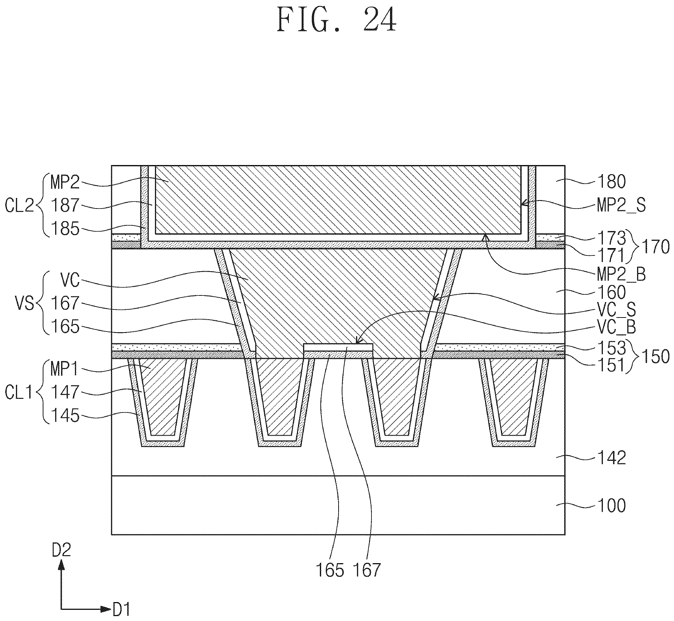

FIG. 24 is a cross-sectional view of a semiconductor device according to some embodiments of the inventive concept. To simplify description, differences from the semiconductor device described with reference to FIG. 18 will be mainly described.

Referring to FIG. 24, an upper conductive line CL2 may be disposed in the second upper insulating film 180. The upper conductive line CL2 may penetrate or extend through the second upper insulating film 180 and the second etch stopping film 170, and may be electrically connected to the via structure VS. The upper conductive line CL2 may be electrically connected to the at least two corresponding lower conductive lines CL1 through the via structure VS.

The upper conductive line CL2 may include an upper metal line MP2 penetrating or extending through the second etch stopping film 170 and the second upper insulating film 180, an upper barrier pattern 185 extending along a side surface MP2_S and a bottom surface MP2_B of the upper metal line MP2, and an upper liner pattern 187 interposed between the side surface MP2_S of the upper metal line MP2 and the upper barrier pattern 185, and between the bottom surface MP2_B of the upper metal line MP2 and the upper barrier pattern 185. The upper barrier pattern 185 and the upper liner pattern 187 may be interposed between the side surface MP2_S of the upper metal line MP2 and the second upper insulating film 180, and may extend between the side surface MP2_S of the upper metal line MP2 and the second etch stopping film 170. The upper barrier pattern 185 and the upper liner pattern 187 may further extend between the bottom surface MP2_B of the upper metal line MP2 and the first upper insulating film 160, and between the bottom surface MP2_B of the upper metal line MP2 and the via structure VS. The upper metal line MP2 may be spaced apart from the via contact VC with the upper barrier pattern 185 and the upper liner pattern 187 therebetween.

The via contact VC may penetrate or extend through the barrier pattern 165 and the liner pattern 167 to be in contact with the corresponding lower conductive lines CL1, and may be in contact with the lower metal line MP1 of each of the corresponding lower conductive lines CL1. According to the present embodiments, the via contact VC may be in direct contact with the lower metal line MP1 of each of the corresponding lower conductive lines CL1, and thus resistance of the via structure VS electrically connecting the upper conductive line CL2 and the corresponding lower conductive lines CL1 may be reduced.

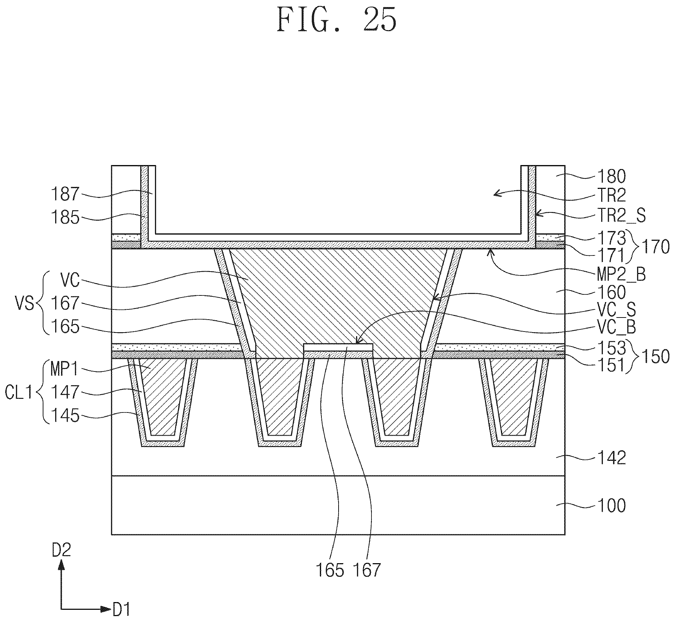

FIG. 25 is a cross-sectional view illustrating a method for manufacturing a semiconductor device according to some embodiments of the inventive concept. To simplify description, differences from the method for manufacturing a semiconductor device described with reference to FIGS. 19 to 22 will be mainly described.

Referring to FIG. 25, a second trench TR2 may be formed to penetrate or extend through the second etch stopping film 170 and the second upper insulating film 180. The second trench TR2 may expose the via structure VS. The second trench TR2 may expose an upper surface of the via contact VC, and uppermost surfaces of the barrier pattern 165 and the liner pattern 167.

An upper barrier pattern 185 may be formed to conformally at least partially cover an inner surface of the second trench TR2. The upper barrier pattern 185 may extend along a side surface TR2_S and a bottom surface TR2_B of the second trench TR2, and may at least partially cover the via structure VS exposed by the second trench TR2.

The upper liner pattern 187 may be formed on the upper barrier pattern 185. The upper liner pattern 187 may extend along the side surface TR2_S and the bottom surface TR2_B of the second trench TR2, and may extend onto the via structure VS.

Referring back to FIG. 24, an upper metal line MP2 that at least partially fills a residual portion of the second trench TR2 may be formed. The upper metal line MP2 may be formed in the substantially same method as the method for manufacturing the semiconductor device described with reference to FIGS. 19 to 22. The upper barrier pattern 185 and the upper liner pattern 187 may be interposed between the upper metal line MP2 and the via structure VS.

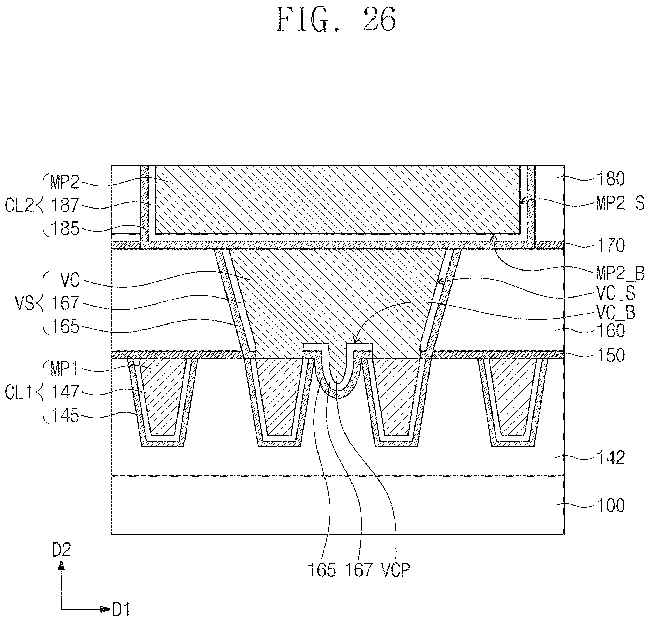

FIG. 26 is a cross-sectional view of a semiconductor device according to some embodiments of the inventive concept. To simplify description, differences from the semiconductor device described with reference to FIG. 24 will be mainly described.

Referring to FIG. 26, each of the first etch stopping film 150 and the second etch stopping film 170 may have a single-layered structure, and may include aluminum oxide (AlO), aluminum nitride (AlN), aluminum oxynitride (AlON), SiCN, SiOC, MoN, manganese nitride (MnN), GaN, and/or AlGaN. For example, each of the first etch stopping film 150 and the second etch stopping film 170 may include aluminum oxide (AlO).

The via contact VC may have a protrusion VCP extending into the lower insulating film 142 between the corresponding lower conductive lines CL1. The protrusion VCP of the via contact VC may be interposed between the corresponding lower conductive lines CL1. The barrier pattern 165 may be interposed between the protrusion VCP and the lower insulating film 142, and the liner pattern 167 may be interposed between the protrusion VCP and the barrier pattern 165. The protrusion VCP of the via contact VC may be spaced apart from the lower insulating film 142 with the barrier pattern 165 and the liner pattern 167 therebetween.

The barrier pattern 165 and the liner pattern 167 may extend onto uppermost surfaces of the lower barrier pattern 145 and the lower liner pattern 147 of each of the corresponding lower conductive lines CL1, and may be in contact with the uppermost surfaces of the lower barrier pattern 145 and the lower liner pattern 147.

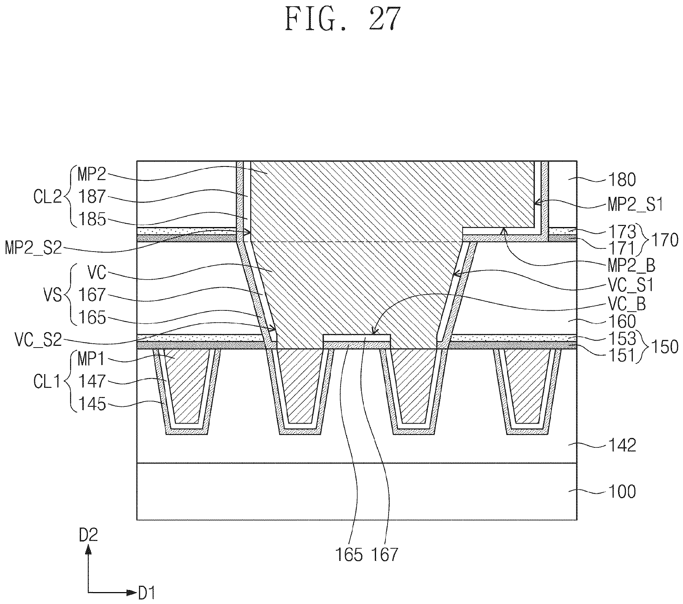

FIGS. 27 to 30 are cross-sectional views of a semiconductor device according to some embodiments of the inventive concept.

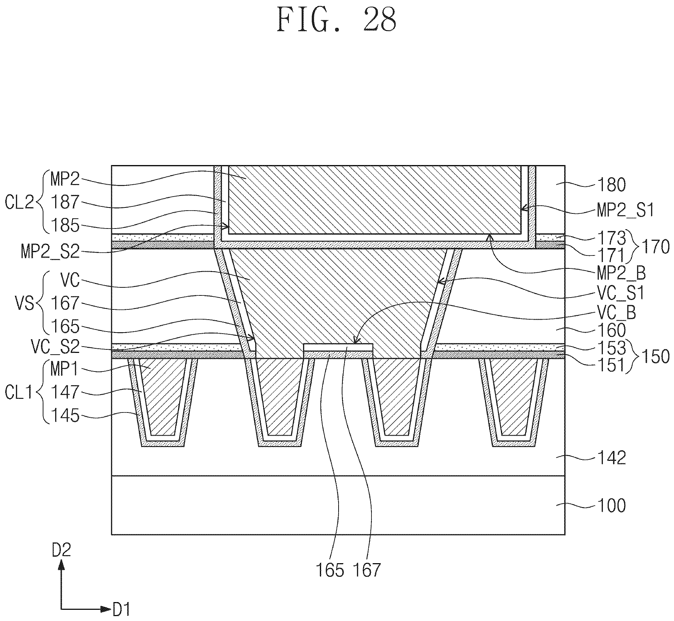

Referring to FIGS. 27 and 28, the upper metal line MP2 may extend on the via contact VC in the first direction D1. The upper metal line MP2 may extend across a first side surface VC_S1 of the via contact VC onto the first upper insulating film 160 along the first direction D1. Accordingly, a first side surface MP2_S1 of the upper metal line MP2 may be shifted from the first side surface VC_S1 of the via contact VC along the first direction D1, and a bottom surface MP2_B of the upper metal line MP2 may extend, in the first direction D1, between the first side surface VC_S1 of the via contact VC and the first side surface MP2_S1 of the upper metal line MP2.

According to some embodiments, a second side surface MP2_S2 of the upper metal line MP2 may be aligned with a second side surface VC_S2 of the via contact VC along the second direction D2. The first side surface MP2_S1 and the second side surface MP2_S2 of the upper metal line MP2 may be opposed to each other in the first direction D1, and the first side surface VC_S1 and the second side surface VC_S2 of the via contact VC may be opposed to each other in the first direction D1.

Except for the difference described above, a semiconductor device of FIG. 27 is substantially the same as the semiconductor device described with reference to FIG. 18, and a semiconductor device of FIG. 28 is substantially the same as the semiconductor device described with reference to FIG. 24.

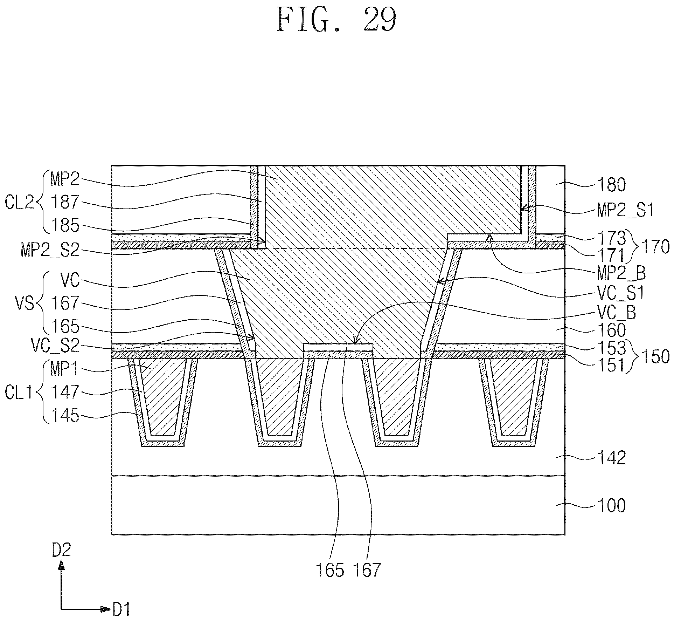

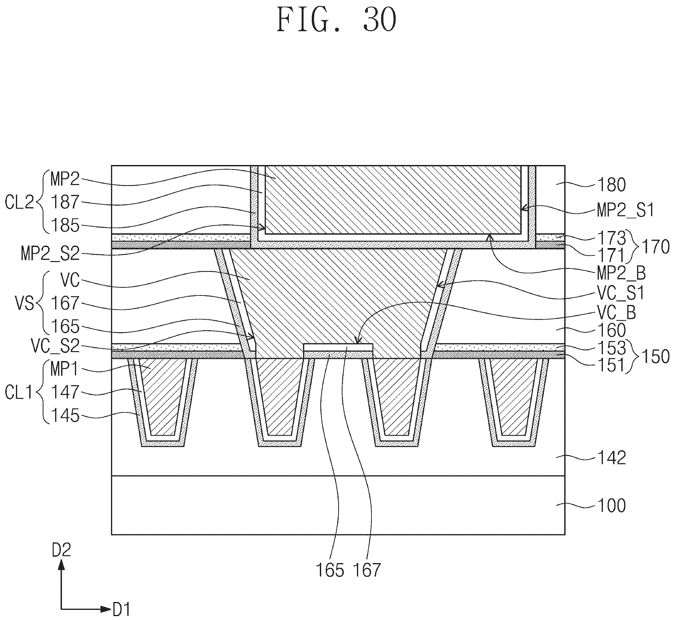

Referring to FIGS. 29 and 30, the upper metal line MP2 may extend on the via contact VC in the first direction D1. The upper metal line MP2 may extend across a first side surface VC_S1 of the via contact VC onto the first upper insulating film 160 along the first direction D1. Accordingly, a first side surface MP2_S1 of the upper metal line MP2 may be shifted from the first side surface VC_S1 of the via contact VC along the first direction D1, and a bottom surface MP2_B of the upper metal line MP2 may extend, in the first direction D1, between the first side surface VC_S1 of the via contact VC and the first side surface MP2_S1 of the upper metal line MP2.

According to some embodiments, a second side surface MP2_S2 of the upper metal line MP2 may be shifted from a second side surface VC_S2 of the via contact VC along the first direction D1. The second etch stopping film 170 may extend onto uppermost surfaces of the barrier pattern 165 and the liner pattern 167 on the second side surface VC_S2 of the via contact VC, and may extend across the second side surface VC_S2 of the via contact VC onto an upper surface of the via contact VC.

Except for the difference described above, a semiconductor device of FIG. 29 is substantially the same as the semiconductor device described with reference to FIG. 18, and a semiconductor device of FIG. 30 is substantially the same as the semiconductor device described with reference to FIG. 24.

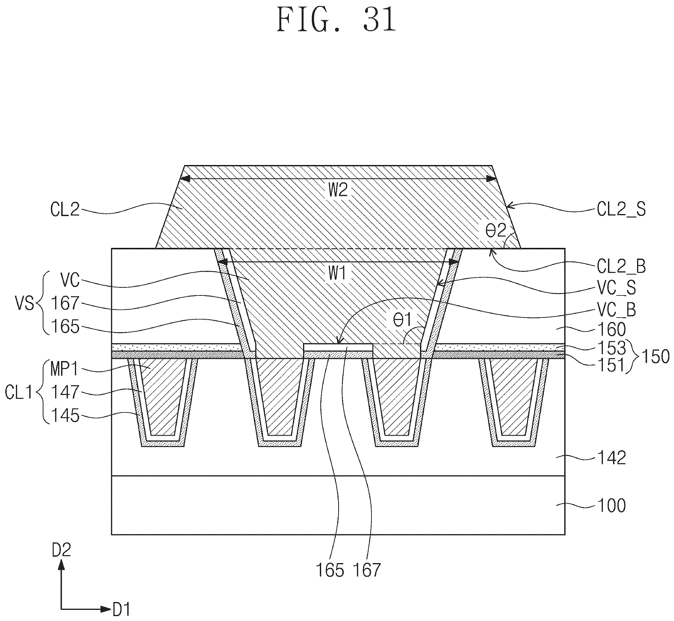

FIG. 31 is a cross-sectional view of a semiconductor device according to some embodiments of the inventive concept. To simplify description, differences from the semiconductor device described with reference to FIG. 1 will be mainly described.

Referring to FIG. 31, a via structure VS may be disposed in the upper insulating film 160. The via structure VS may penetrate or extend through the etch stopping film 150 and the upper insulating film 160, and may extend in the first direction D1 to be connected to at least two corresponding lower conductive lines CL1 among the lower conductive lines CL1.

The via structure VS may include a via contact VC penetrating or extending through the etch stopping film 150 and the upper insulating film 160, a barrier pattern 165 disposed on a side surface VC_S and a bottom surface VC_B of the via contact VC, and a liner pattern 167 interposed between the side surface VC_S of the via contact VC and the barrier pattern 165, and between the bottom surface VC_B of the via contact VC and the barrier pattern 165. The via contact VC may penetrate or extend through the barrier pattern 165 and the liner pattern 167 to be in contact with the corresponding lower conductive lines CL1, and may be in contact with the lower metal line MP1 of each of the corresponding lower conductive lines CL1.

An upper conductive line CL2 may be disposed on the upper insulating film 160. The upper conductive line CL2 may extend, along the first direction D1, across the side surface VC_S of the via contact VC onto the upper insulating film 160. The upper conductive line CL2 may be in contact with the via contact VC, and may be in contact with uppermost surfaces of the barrier pattern 165 and the liner pattern 167.

The side surface VC_S of the via contact VC may be inclined to have a first angle θ1 with respect to the bottom surface VC_B of the via contact VC, and the first angle θ1 may be equal to or greater than about 90°. For example, the first angle θ1 may be greater than about 90°. The via structure VS may have a first width W1 along the first direction D1. The first width W1 of the via structure VS may increase along a direction (for example, the second direction D2) getting farther from the substrate 100.

A side surafce CL2_S of the upper conductive line CL2 may be inclined to have a second angle θ2 with respect to a bottom surafce CL2_B of the upper conductive line CL2, and the second angle θ2 may be equal to or less than about 90°. For example, the second angle θ2 may be less than about 90°. The upper conductive line CL2 may have a second width W2 along the first direction D1. The second width W2 of the upper conductive line CL2 may decrease along a direction (for example, the second direction D2) getting farther from the substrate 100.

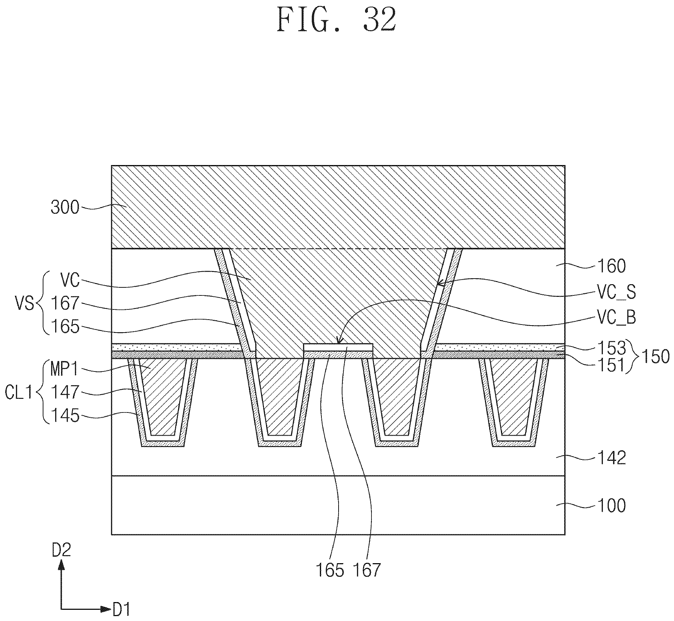

FIG. 32 is a cross-sectional view illustrating a method for manufacturing a semiconductor device according to some embodiments of the inventive concept. In order to simplify description, differences from the method for manufacturing a semiconductor device described with reference to FIGS. 2 to 4 will be mainly described.

Referring to FIG. 32, a via structure VS may be formed to penetrate or extend through the etch stopping film 150 and the upper insulating film 160. The via structure VS may be formed in the substantially same method as that for manufacturing the via structure VS described with reference to FIGS. 19 to 21. An upper conductive film 300 may be formed on the upper insulating film 160, and may at least partially cover the via structure VS.

Referring back to FIG. 31, an upper conductive line CL2 may be formed by patterning the upper conductive film 300. For example, forming the upper conductive line CL2 may include forming a mask pattern on the upper conductive film 300, and etching the upper conductive film 300 using the mask pattern as an etching mask.

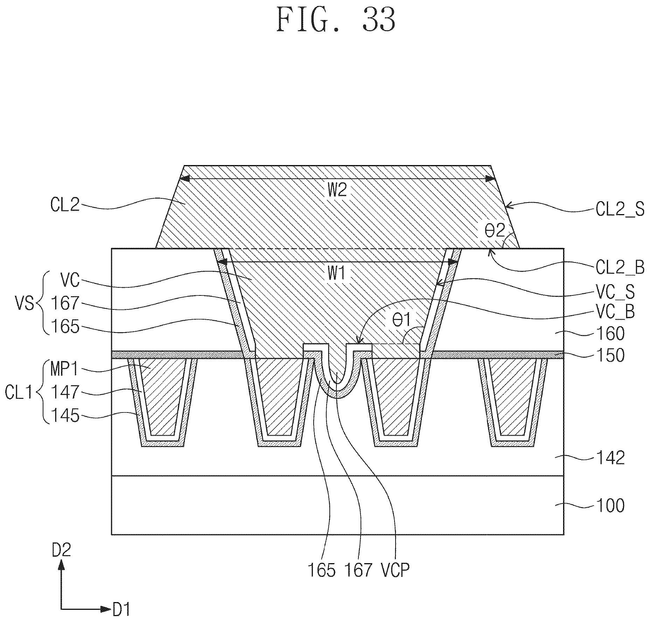

FIG. 33 is a cross-sectional view of a semiconductor device according to some embodiments of the inventive concept. To simplify description, differences from the semiconductor device described with reference to FIG. 31 will be mainly described.

Referring to FIG. 33, the etch stopping film 150 may have a single-layered structure, and may include aluminum oxide (AlO), aluminum nitride (AlN), aluminum oxynitride (AlON), SiCN, SiOC, MoN, manganese nitride (MnN), GaN, and/or AlGaN. For example, the etch stopping film 150 may include aluminum oxide (AlO).

The via contact VC may have a protrusion VCP extending into the lower insulating film 142 between the corresponding lower conductive lines CL1. The protrusion VCP of the via contact VC may be interposed between the corresponding lower conductive lines CL1. The barrier pattern 165 may be interposed between the protrusion VCP and the lower insulating film 142, and the liner pattern 167 may be interposed between the protrusion VCP and the barrier pattern 165. The protrusion VCP of the via contact VC may be spaced apart from the lower insulating film 142 with the barrier pattern 165 and the liner pattern 167 therebetween.

The barrier pattern 165 and the liner pattern 167 may extend onto uppermost surfaces of the lower barrier pattern 145 and the lower liner pattern 147 of each of the corresponding lower conductive lines CL1, and may be in contact with the uppermost surfaces of the lower barrier pattern 145 and the lower liner pattern 147.

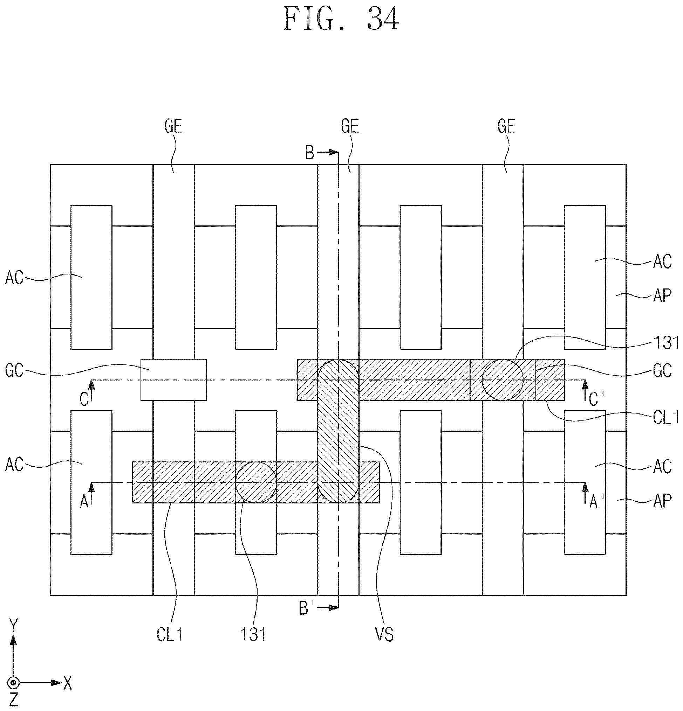

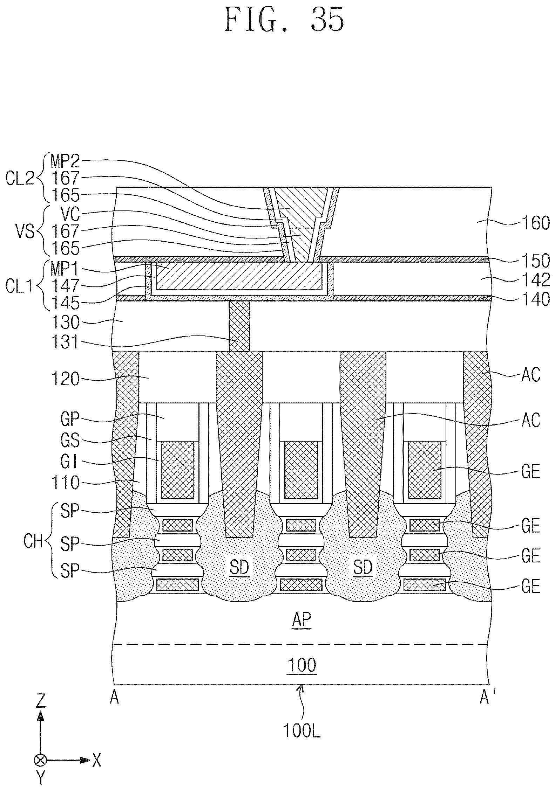

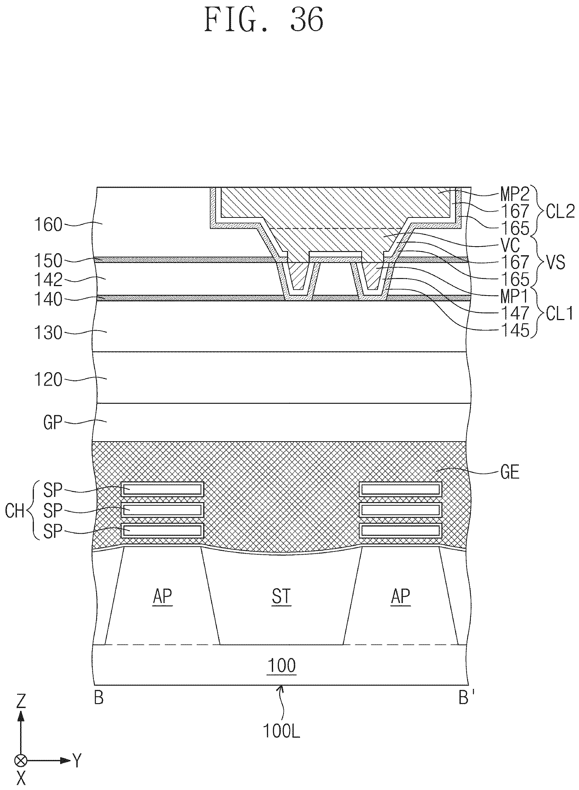

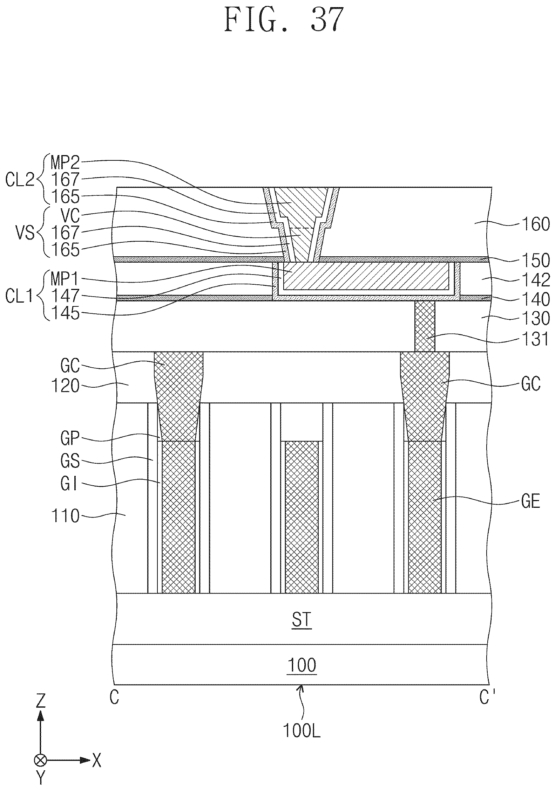

FIG. 34 is a plan view of a semiconductor device according to some embodiments of the inventive concept. FIGS. 35, 36, and 37 are cross-sectional views taken along A-A', B-B', and C-C' of FIG. 34, respectively.

Referring to FIGS. 34 to 37, active patterns AP may be disposed on a substrate 100. The substrate 100 may include a semiconductor substrate. For example, the substrate 100 may be a silicon substrate, a germanium substrate, or a silicon-on-insulator (SOI) substrate. The active patterns AP may extend in an X direction, and may be spaced apart from each other in a Y direction. The X direction and the Y direction may be parallel to a lower surface 100L of the substrate 100, and may cross each other. The active patterns AP may protrude from the substrate 100 along a Z direction perpendicular to the lower surface of the substrate 100.

A device isolation film ST may be disposed on the substrate 100, and may at least partially cover side surfaces of the active patterns AP. The device isolation film ST may include an insulating material, for example, silicon oxide, silicon nitride, and/or silicon oxynitride.

Channel structures CH may be disposed on each of the active patterns AP, and may be spaced apart from each other on each of the active patterns AP in the X direction. Each of the channel structures CH may include a plurality of semiconductor patterns SP spaced apart from each other in the Z direction. The plurality of semiconductor patterns SP may vertically overlap each other in the Z direction. The plurality of semiconductor patterns SP may include a semiconductor material, for example, silicon.

Source/drain patterns SD may be disposed on each of the active patterns AP, and may be spaced apart from each other on each of the active patterns AP in the X direction. The channel structures CH and the source/drain patterns SD may be alternately arranged on each of the active patterns AP in the X direction. Each of the channel structures CH may be interposed between a pair of source/drain patterns SD adjacent to each other in the X direction. The plurality of semiconductor patterns SP of each of the channel structures CH may be connected (for example, electrically connected) to the pair of source/drain patterns SD. The source/drain patterns SD may include a semiconductor material, for example, silicon (Si), silicon-germanium (SiGe), and/or germanium (Ge). The source/drain patterns SD may be P-type or N-type conductive. The source/drain patterns SD may include a P-type impurity or an N-type impurity.

Gate electrodes GE may be disposed on the active patterns AP. The gate electrodes GE may be spaced apart from each other on the active patterns AP in the X direction, and may extend in the Y direction to cross the active patterns AP and the element isolation film ST. The gate electrodes GE may be disposed on the channel structures CH, and may vertically overlap the channel structures CH along the Z direction. Each of the gate electrodes GE may extend between the plurality of semiconductor patterns SP of each of the channel structures CH, and between the lowest semiconductor pattern of the plurality of semiconductor patterns SP and each of the active patterns AP. The source/drain patterns SD may be disposed on both sides of each of the gate electrodes GE. Each gate electrode GE, each channel structure CH, and a pair of source/drain patterns SD connected to the each channel structure CH may constitute a three-dimensional field effect transistor (for example, MBCFET, or GAAFET). According to some embodiments, each of the channel structures CH may include a semiconductor pattern (for example, an active fin) protruding from each of the active patterns AP in the Z direction, and in this case, each gate electrode GE, each channel structure CH, and a pair of the source/drain patterns SD connected to the each channel structure CH may constitute a fin field effect transistor.

Gate spacers GS may be disposed on both side surfaces of each of the gate electrodes GE. The gate spacers GS may extend along both side surfaces of each of the gate electrodes GE in the Y direction. Upper surfaces of the gate spacers GS may be placed more highly in the Z direction than an upper surface of each of the gate electrodes GE. A gate capping pattern GP may be disposed on the upper surface of each of the gate electrodes GE. The gate capping pattern GP may extend along the upper surface of each of the gate electrodes GE in the Y direction. For example, the gate spacers GS and the gate capping pattern GP may include silicon nitride.

A gate insulating film GI may be interposed between each of the gate electrodes GE and each of the channel structures CH. The gate insulating film GI may extend between each of the plurality of semiconductor patterns SP and each of the gate electrodes GE, and between each of the active patterns AP and each of the gate electrodes GE, and may extend between each of the source/drain patterns SD and each of the gate electrodes GE. The gate insulating film GI may further extend between each of the gate spacers GS and each of the gate electrodes GE. For example, the gate insulating film GI may include a high dielectric constant film such as hafnium oxide, and/or silicon oxide.

A first insulating film 110 may be disposed to cover the source/drain patterns SD and the gate spacers GS. An upper surface of the first insulating film 110 may be coplanar with an upper surface of the gate capping pattern GP and upper surfaces of the gate spacers GS. A second insulating film 120 may be disposed on the first insulating film 110, and may at least partially cover the upper surface of the gate capping pattern GP and the upper surfaces of the gate spacers GS. For example, the first insulating film 110 and the second insulating film 120 may include silicon oxide, silicon nitride, silicon oxynitride, and/or low dielectric constant films.

Active contacts AC may be disposed in the first and second insulating films 110 and 120, and between the gate electrodes GE. Each of the active contacts AC may penetrate or extend through the first and second insulating films 110 and 120 to be electrically connected to the corresponding source/drain patterns SD among the source/drain patterns SD. Each of the active contacts AC may have a shape of a bar extending in the Y direction. Gate contacts GC may be disposed in the second insulating film 120, and on the gate electrodes GE. Each of the gate contacts GC may penetrate or extend through the second insulating film 120 and the gate capping pattern GP to be electrically connected to the corresponding gate electrode GE among the gate electrodes GE. Upper surfaces of the active contacts AC and the gate contacts GC may be coplanar with an upper surface of the second insulating film 120. The active contacts AC and the gate contacts GC may include metal and/or conductive metal nitride, for example, aluminum, copper, tungsten, molybdenum, cobalt, titanium, tantalum, titanium nitride (TiN), tantalum nitride (TaN), tungsten nitride (WN), nickel nitride (NiN), cobalt nitride (CoN), and/or platinum nitride (PtN). The active contacts AC and the gate contacts GC may include the same material.

A third insulating film 130 may be disposed on the second insulating film 120, and may at least partially cover upper surfaces of the active contacts AC and the gate contacts GC. Conductive contacts 131 may be disposed in the third insulating film 130. Each of the conductive contacts 131 may be electrically connected to a corresponding one among the active contacts AC and the gate contacts GC. The conductive contacts 131 may include metal and/or conductive metal nitride. A protective film 140 may be disposed on the third insulating film 130. For example, the third insulating film 130 may include silicon oxide, silicon nitride, silicon oxynitride, and/or low dielectric constant films, and the protective film 140 may include, for example, silicon nitride.

A lower insulating film 142 may be disposed on the protective film 140, and lower conductive lines CL1 may be disposed in the lower insulating film 142. The lower insulating film 142 and lower conductive lines CL1 are substantially the same as the lower insulating film 142 and the lower conductive lines CL1 of FIG. 1. Each of the lower conductive lines CL1 may penetrate or extend through the lower insulating film 142 and the protective film 140 to be electrically connected to the corresponding conductive contact 131 among the conductive contacts 131. According to some embodiments, one line among the lower conductive lines CL1 may be electrically connected through the corresponding conductive contact 131 to the corresponding active contact AC, and another line among the lower conductive lines CL1 may be electrically connected through the corresponding conductive contact 131 to the corresponding gate contact GC.

A etch stopping film 150 may be disposed on the lower insulating film 142, and may extend onto upper surfaces of the lower conductive lines CL1. The etch stopping film 150 is substantially the same as the etch stopping film 150 of FIG. 1. An upper insulating film 160 may be disposed on the etch stopping film 150. The upper insulating film 160 is substantially the same as the upper insulating film 160 of FIG. 1.

A via structure VS and an upper conductive line CL2 may be disposed in the upper insulating film 160. The via structure VS may penetrate or extend through a lower portion of the upper insulating film 160 and the etch stopping film 150, and may extend in the Y direction to be connected to the one among the lower conductive lines CL1 and the other one among the lower conductive lines CL1. The upper conductive line CL2 may penetrate or extend through an upper portion of the upper insulating film 160, and may be connected to the via structure VS. The upper conductive line CL2 may be electrically connected, through the via structure VS, to the one among the lower conductive lines CL1, and the other one among the lower conductive lines CL1. The via structure VS and the upper conductive line CL2 are substantially the same as the via structure VS and the upper conductive line CL2 of FIG. 1.

According to embodiments of the inventive concept, the lower insulating film 142, the lower conductive lines CL1, the etch stopping film 150, the upper insulating film 160, the via structure VS, and the upper conductive line CL2 may be variously transformed as described with reference to FIGS. 1 to 33.

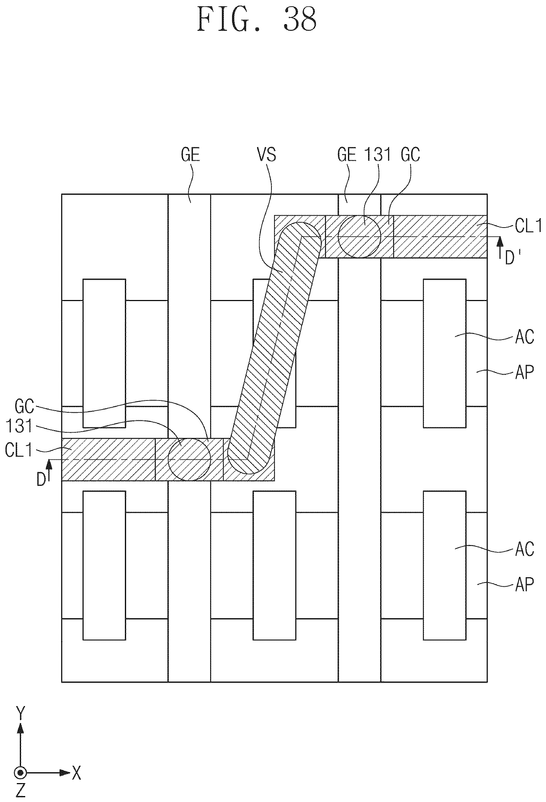

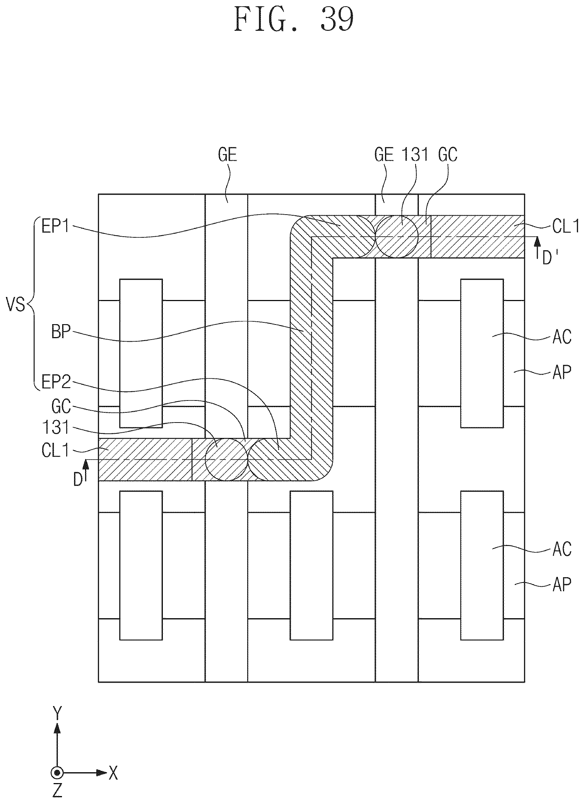

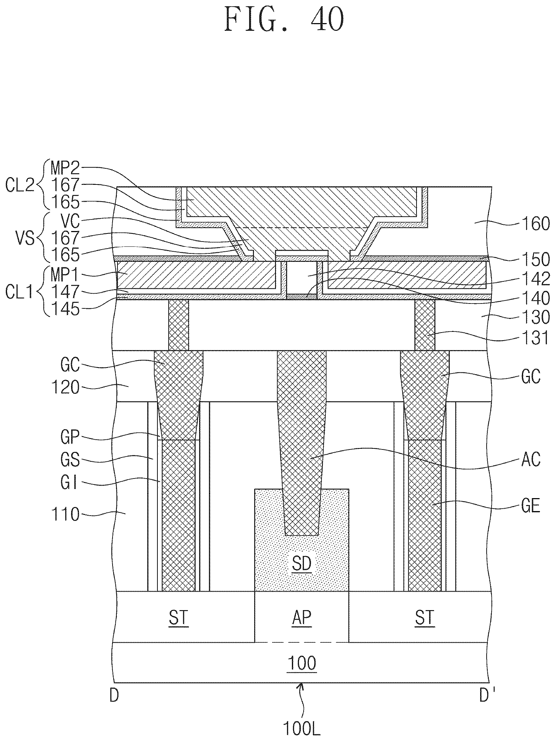

FIGS. 38 and 39 are plan views of a semiconductor device according to some embodiments of the inventive concept. FIG. 40 is a cross-sectional view taken along D-D' of FIGS. 38 and 39. To simplify description, differences from the semiconductor device described with reference to FIGS. 34 to 37 will be mainly described.

Referring to FIGS. 38 to 40, according to some embodiments, one line among the lower conductive lines CL1 may be electrically connected to one contact among the gate contacts GC through a corresponding conductive contact 131, and another line among the lower conductive lines CL1 may be electrically connected to another contact among the gate contacts GC through a corresponding conductive contact 131. The via structure VS may penetrate or extend through a lower portion of the upper insulating film 160 and the etch stopping film 150, and may extend in a direction parallel to a lower surface 100L of the substrate 100 to be connected to the one among the lower conductive lines CL1 and the other one among the lower conductive lines CL1.

According to some embodiments, as illustrated in FIG. 38, the via structure VS may have a shape of a bar extending in one direction parallel to the lower surface 100L of the substrate 100 and crossing the X direction and the Y direction. According to other embodiments, as illustrated in FIG. 39, the via structure VS may have a bent shape including a body portion BP extending in the Y direction, a first extension portion EP1 extending from one end of the body portion BP in the X direction, and a second extension portion EP2 extending from the other end of the body portion BP in an opposite direction of the X direction. In this case, the first extension portion EP1 of the via structure VS may be connected to the one among the lower conductive lines CL1, and the second extension portion EP2 of the via structure VS may be connected to the other one among the lower conductive lines CL1.

The upper conductive line CL2 may be electrically connected, through the via structure VS, to the one among the lower conductive lines CL1 and the other one among the lower conductive lines CL1.

According to embodiments of the inventive concept, lower conductive lines may be disposed in a lower insulating film, and an etch stopping film and an upper insulating film may be sequentially stacked on the lower insulating film. A via structure may penetrate or extend through at least a portion of the upper insulating film and the etch stopping film, and may extend in a first direction to be connected to at least two lower conductive lines. The etch stopping film may have a single-layered structure or a double-layered structure, and thus parasitic capacitance of a semiconductor device including the lower conductive lines, the via structure, and the upper conductive line may be reduced.

Furthermore, the via structure may include a via contact penetrating or extending through at least a portion of the upper insulating film and the etch stopping film to be connected to the at least two lower conductive lines, and a barrier pattern disposed on a side surface and a bottom surface of the via contact. The via contact may penetrate or extend through the barrier pattern to be in direct contact with the lower conductive lines. Accordingly, resistance of the via structure may be reduced.

Therefore, the semiconductor device with improved electrical characteristics may be provided.

The above description of embodiments of the inventive concept provides an example for description of the inventive concept. Therefore, the inventive concept is not limited to the above embodiments, and it is obvious that various modifications and changes such as combining the above embodiments may be made by those skilled in the art within the technical spirit of the inventive concept.

## Claims

1. A semiconductor device comprising:
lower conductive lines on a substrate and spaced apart from each other in a first direction parallel to an upper surface of the substrate; and
a via structure on the lower conductive lines and electrically connected to the lower conductive lines,
wherein the via structure includes:
a via contact extending in the first direction and electrically connected to the lower conductive lines; and
a barrier pattern on a side surface of the via contact and on a bottom surface of the via contact between the lower conductive lines, and
wherein the via contact extends through the barrier pattern and contacts the lower conductive lines.

2. The semiconductor device of claim 1, wherein the via structure further comprises a liner pattern interposed between the side surface of the via contact and the barrier pattern, and between the bottom surface of the via contact and the barrier pattern, and
wherein the via contact extends through the liner pattern and the barrier pattern and contacts the lower conductive lines.

3. The semiconductor device of claim 2, further comprising:
a lower insulating film on the substrate;
an upper insulating film on the lower insulating film; and
an etch stopping film between the lower insulating film and the upper insulating film,
wherein the lower conductive lines are in the lower insulating film,
wherein the via structure extends through the upper insulating film and the etch stopping film and contacts the lower conductive lines, and
wherein the etch stopping film has a single-layered structure or double-layered structure.

4. The semiconductor device of claim 3, wherein the etch stopping film has a single-layered structure,
wherein the via contact comprises a protrusion extending into the lower insulating film between the lower conductive lines, and
wherein the barrier pattern and the liner pattern are interposed between the protrusion and the lower insulating film.

5. The semiconductor device of claim 1, wherein each of the lower conductive lines comprises:
a lower metal line;
a lower barrier pattern extending along a side surface and a bottom surface of the lower metal line; and
a lower liner pattern interposed between the side surface of the lower metal line and the lower barrier pattern, and between the bottom surface of the lower metal line and the lower barrier pattern, and
wherein the via contact is a metal pattern composed of a single metal, and extends through the barrier pattern to contact the lower metal line of each of the lower conductive lines.

6. The semiconductor device of claim 5, wherein the barrier pattern contacts the side surface and the bottom surface of the via contact.

7. The semiconductor device of claim 6, further comprising:
a lower insulating film on the substrate;
an upper insulating film on the lower insulating film; and
an etch stopping film between the lower insulating film and the upper insulating film,
wherein the lower conductive lines are in the lower insulating film,
wherein the via structure extends through the upper insulating film and the etch stopping film to electrically connect to the lower conductive lines, and
wherein the etch stopping film has a single-layered structure or double-layered structure.

8. The semiconductor device of claim 7, wherein the etch stopping film has a single-layered structure,
wherein the via contact comprises a protrusion extending into the lower insulating film between the lower conductive lines, and
wherein the barrier pattern is interposed between the protrusion and the lower insulating film.

9. The semiconductor device of claim 1, further comprising an upper conductive line extending on the via structure in the first direction,
wherein the upper conductive line is electrically connected to the lower conductive lines through the via structure, and
wherein the via contact contacts the upper conductive line.

10. The semiconductor device of claim 9, wherein the upper conductive line comprises:
an upper metal line that contacts the via contact and extends in the first direction; and
the barrier pattern extending from the side surface of the via contact to a side surface of the upper metal line.

11. The semiconductor device of claim 9, wherein the upper conductive line comprises:
an upper metal line extending in the first direction; and
an upper barrier pattern interposed between the upper metal line and the via contact and extending onto a side surface of the upper metal line, and
wherein the via contact contacts the upper barrier pattern.

12. The semiconductor device of claim 9, wherein an angle between the side surface of the via contact and the bottom surface of the via contact is greater than about 90°, and
wherein an angle between a side surface of the upper conductive line and a bottom surface of the upper conductive line is smaller than about 90°.
